(19) Europäisches Patentamt
European Patent Office
Office européen des brevets

(11) **EP 2 377 239 B1**

(12) **EUROPÄISCHE PATENTSCHRIFT**

(45) Veröffentlichungstag und Bekanntmachung des Hinweises auf die Patenterteilung:
**31.07.2013 Patentblatt 2013/31**

(21) Anmeldenummer: **10701491.2**

(22) Anmeldetag: **13.01.2010**

(51) Int Cl.:
*H02H 7/08* (2006.01)    *H02P 29/02* (2006.01)

(86) Internationale Anmeldenummer:
**PCT/EP2010/050346**

(87) Internationale Veröffentlichungsnummer:
**WO 2010/081822 (22.07.2010 Gazette 2010/29)**

(54) **FEHLERDETEKTIONSMETHODE FÜR ELEKTRISCHE MOTOREN MIT EINEM ODER MEHREREN STERNPUNKTEN**

ERROR DETECTION METHOD FOR ELECTRICAL MOTORS HAVING ONE OR MORE STAR POINTS

PROCÉDÉ DE DÉTECTION DE PANNE POUR DES MOTEURS ÉLECTRIQUES COMPORTANT UN OU PLUSIEURS POINTS NEUTRES

(84) Benannte Vertragsstaaten:
**AT BE BG CH CY CZ DE DK EE ES FI FR GB GR HR HU IE IS IT LI LT LU LV MC MK MT NL NO PL PT RO SE SI SK SM TR**

(30) Priorität: **14.01.2009 DE 102009004556**

(43) Veröffentlichungstag der Anmeldung:
**19.10.2011 Patentblatt 2011/42**

(73) Patentinhaber: **EADS Deutschland GmbH**
**85521 Ottobrunn (DE)**

(72) Erfinder: **CHRISTMANN, Markus**
**81375 München (DE)**

(74) Vertreter: **Kopf, Korbinian Paul**
**Maiwald Patentanwalts GmbH**
**Elisenhof**
**Elisenstrasse 3**
**80335 München (DE)**

(56) Entgegenhaltungen:
**DE-A1- 10 327 142      DE-A1-102007 027 481**
**US-A1- 2006 122 796      US-A1- 2007 210 732**

**Beschreibung**

**Gebiet der Erfindung**

Die Erfindung betrifft die Fehlerdetektion und Steuerung von Elektromotoren mit Sternpunkttopologie. Insbesondere betrifft die Erfindung eine Detektions- und Steuervorrichtung mit einer Auswertungseinheit, einer Steuereinheit und einer Rückführungseinheit. Ferner betrifft die Erfindung einen Elektromotor, ein Luftfahrzeug und ein Landeklappenantriebssystem sowie ein Verfahren zur Detektion eines Motorfehlers eines Elektromotors.

**Hintergrund der Erfindung**

Teilkurzschlüsse in permanent erregten Elektromotoren (PMSM) sind schwer zu detektieren und können über die Rückinduktionsspannung zu sehr hohen Kurzschlussströmen und sehr hohen Heizraten im Bereich von 1.000 K/s führen, wenn nicht der komplette zugehörige Wicklungsstrang kurzgeschlossen wird. Dieses Problem ist bei allen redundant aufgebauten PMSM-Antrieben relevant, bei denen der Rotor eines defekten Motors weiterdrehen soll. Dabei handelt es sich insbesondere um intern redundante Motoren und Drehmoment addierende Motoren auf einer bzw. mehreren gekoppelten Wellen. Besonders schwer detektierbar sind Teilkurzschlüsse in Motoren mit Sternpunktverschaltungen der Wicklungen.

Teilkurzschlüsse in Motoren können durch eine Auswertung des an den Motorklemmen eines Elektromotors gemessenen Stroms nur unzulänglich detektiert und ausgewertet werden - insbesondere in Motoren mit Stempunktverschaltung der Wicklungen.

**Zusammenfassung der Erfindung**

Es kann als Aufgabe der Erfindung angesehen werden, eine Vorrichtung und ein Verfahren zur besseren Bestimmung von Motorfehlern in permanent erregten Elektromotoren mit Sternpunkttopologie anzugeben.

Die Aufgabe der Erfindung wird durch den Gegenstand der unabhängigen Ansprüche gelöst, während vorteilhafte Weiterentwicklungen der Erfindung durch die abhängigen Ansprüche verkörpert werden.

Gemäß einer beispielhaften Ausführung der Erfindung wird eine Detektions- und Steuervorrichtung zur Detektion eines Motorfehlers eines Elektromotors mit Stempunkttopologie bereitgestellt, wobei die Detektions- und Steuervorrichtung eine Auswertungseinheit, eine Steuereinheit, eine Rückführungseinheit und mehrere Steuerleitungen aufweist. Die Rückführungseinheit ist zur Rückführung eines oder mehrerer Stempunktpotentiale des Elektromotors an die Auswertungseinheit ausgeführt, die Auswertungseinheit ist zur Auswertung des/der Sternpunktpotenziale ausgeführt und die Steuereinheit ist zur Passivierung eines Motorfehlers auf Basis der Auswertung ausgeführt.

Eine derartige Detektions- und Steuervorrichtung ermöglicht die Detektion und Passivierung eines Motorfehlers durch einen Komplettkurzschluss des zugehörigen Sternpunktsystems. Dadurch und in Verbindung mit einem geeigneten Magnetkreisdesign des Motors ist eine Begrenzung des Kurzschlussstromes und des resultierenden Störmomentes auf unkritische Werte möglich. Bei redundanter Motorausführung kann der Antrieb weiter betrieben werden. Fehlerausbreitung und Folgefehler können vermieden werden. Das Sternpunktpotential wird dabei rückgeführt und ausgewertet.

Gemäß einem Ausführungsbeispiel der Erfindung erfolgt die Auswertung auf Basis eines Vergleichs des Sternpunktpotenzials mit einem Referenzpotential, wobei das Referenzpotential berechnet ist.

Gemäß einer weiteren Ausführung der Erfindung erfolgt die Auswertung auf Basis eines Vergleichs des Sternpunktpotenzials mit einem Referenzpotential, wobei das Referenzpotential analog erzeugt ist.

Gemäß der Erfindung erfolgt die Auswertung auf Basis eines Vergleiches des Stempunktpotentials mit einem Referenzpotential, wobei eine auswertbare Fehlerspannung zwischen Stempunkt- und Referenzpotential durch die Steuereinheit durch das gezielte Einprägen eines Blindstromanteils über die Steuerleitungen in die Statorwicklung des Motors erzeugt wird.

Gemäß einer weiteren Ausführung der Erfindung erfolgt die Passivierung durch Kurzschließen eines Sternpunktsystems, in dem ein Motorfehler detektiert wurde.

Gemäß einem weiteren Ausführungsbeispiel der Erfindung ermöglicht die Passivierung die Begrenzung eines Kurzschlussstromes und eines daraus resultierenden Störmomentes oder einer daraus resultierenden thermischen Überlastung bei einem Elektromotor.

Gemäß einem weiteren Ausführungsbeispiel der Erfindung ist die Rückführungseinheit als Verbindungsleitung zwischen einem Sternpunkt des Elektromotors und der Auswertungseinheit ausgeführt.

Es ist darauf hinzuweisen, dass "umfassend" keine anderen Elemente oder Schritte ausschließt und "eine" oder "ein" keine Vielzahl ausschließt.

Gemäß einem weiteren Ausführungsbeispiel der Erfindung erfolgt die Rückführung des Sternpunktpotentials des Elektromotors an die Steuereinheit durch die Steuerleitungen, so dass die Steuerleitungen die Funktion der Rückführungseinheit und die Steuereinheit die Funktion der Auswertungseinheit mit übernehmen. Das bedeutet, dass die Rückführungseinheit zumindest teilweise die Steuerleitungen aufweist, dass also die Steuerleitungen ein Teil der Rückführungseinheit sind.

Gemäß einem weiteren Ausführungsbeispiel der Erfindung werden als Rückführungseinheit die vorhandenen Steuerleitungen zwischen Verstärker und den Klemmen eines oder mehrerer Sternpunktsysteme des Elektromotors in Verbindung mit Vorrichtungen zur Spannungsmessung verwendet, wobei diese Steuerleitungen, deren eigentlicher Zweck es ist, die Motorströme zu tragen, zu geeigneten Zeitpunkten stromfrei geschaltet und zur Messung des Sternpunktpotentials verwendet werden.

Gemäß einem weiteren Ausführungsbeispiel der Erfindung erfolgt die stromfrei Schaltung und Spannungsmessung an jeder der oben beschriebenen Verbindungsleitungen zum Zeitpunkt des Nulldurchganges der Motor-Rückinduktionsspannung in dem zwischen Sternpunkt und betreffender Motorklemme befindlichen Teil der Motorwicklung.

Gemäß einem weiteren Ausführungsbeispiel der Erfindung erfolgt die Auswertung der Spannungsmessung an einer oder jeder der oben beschriebenen Verbindungsleitungen unter Berücksichtigung der Rückinduktionsspannung des Elektromotors.

Gemäß einem weiteren Ausführungsbeispiel der Erfindung sind die Auswertungseinheit und die Steuereinheit integriert miteinander ausgeführt. Gemäß einer weiteren Ausführung der Erfindung ist ein Elektromotor mit einer erfindungsgemäßen Detektions- und Steuervorrichtung angegeben.

Gemäß einer weiteren beispielhaften Ausführungsform der Erfindung ist ein Luftfahrzeug mit einer erfindungsgemäßen Detektions- und Steuervorrichtung angegeben.

Gemäß einer weiteren Ausführung der Erfindung ist ein Stellantrieb mit einer Detektions- und Steuervorrichtung gemäß der Erfindung angegeben.

Gemäß einer weiteren Ausführung der Erfindung ist ein Landeklappenantriebssystem mit einer Detektions- und Steuervorrichtung gemäß der Erfindung angegeben.

Gemäß einer weiteren Ausführung der Erfindung ist ein Kompressormotor (beispielsweise für eine Turbine oder ein Kabinen-Klimasystem) mit einer Detektions- und Steuervorrichtung gemäß der Erfindung angegeben.

Gemäß einer weiteren Ausführung der Erfindung ist ein Pumpenmotor (beispielsweise für Treibstoff, Kühlmittel, Hydraulik) mit einer Detektions- und Steuervorrichtung gemäß der Erfindung angegeben.

Gemäß einer weiteren Ausführung der Erfindung ist ein elektrischer Generator mit einer Detektions- und Steuervorrichtung gemäß der Erfindung angegeben.

Gemäß einer weiteren Ausführung der Erfindung ist ein Fan- oder Propellerantrieb mit einer Detektions- und Steuervorrichtung gemäß der Erfindung angegeben.

Gemäß einem weiteren Ausführungsbeispiel der Erfindung ist die Verwendung einer Detektions- und Steuervorrichtung in einem Luftfahrzeug beansprucht.

Gemäß einer weiteren Ausführung der Erfindung ist ein Verfahren zur Detektion eines Motorfehlers eines Elektromotors mit Sternpunkttopologie aufgeführt, wobei das Verfahren folgende Schritte aufweist: Das Bereitstellen einer Auswertungseinheit, einer Steuereinheit, einer Rückführungseinheit und von mehreren Steuerleitungen; die Rückführung eines Sternpunktpotenzials des Elektromotors über die Rückführungseinheit an die Auswertungseinheit oder über die Steuerleitungen an die Steuereinheit; die Auswertung des Sternpunktpotenzials durch die Auswertungseinheit oder die Steuereinheit und die Passivierung des Motorfehlers durch die Steuereinheit auf Basis der Auswertung.

Gemäß einer weiteren beispielhaften Ausführungsform der Erfindung ist ein Verfahren bereitgestellt, wobei die Auswertung des Sternpunktpotenzials durch einen Vergleich des Sternpunktpotenzials mit einem Referenzpunkt erfolgt und wobei die Passivierung des Motorfehlers durch Kurzschließen eines Sternpunktsystems erfolgt, in dem ein Motorfehler detektiert wurde.

Die einzelnen Merkmale der verschiedenen Ausführungsbeispiele können selbstverständlich auch untereinander kombiniert werden, wodurch sich zum Teil auch vorteilhafte Wirkungen einstellen können, die über die Summe der Einzelwirkungen hinausgehen, selbst wenn diese nicht ausdrücklich beschrieben sind.

Diese und andere Aspekte der Erfindung werden durch die Bezugnahme auf die hiernach beschriebenen beispielhaften Ausführungsformen erläutert und verdeutlicht.

## Kurze Beschreibung der Zeichnungen

Beispielhafte Ausführungsformen werden im Folgenden mit Bezugnahme auf die folgenden Zeichnungen beschrieben.

**Fig. 1** zeigt eine schematische Darstellung eines Standard PMSM-Antriebs.

**Fig. 2** zeigt eine schematische Darstellung eines Antriebs mit mehreren Drehmoment addierenden PMSMs.

**Fig. 3** zeigt eine schematische Darstellung eines intern redundanten Antriebs mit mehreren Sternpunkt-Systemen.

**Fig. 4** zeigt eine schematische Darstellung eines Windungsschlusses (Teilkurzschluss) in der Wicklung eines Statorzahnes eines Elektromotors mit einem Anker eines Elektromotors.

**Fig. 5** zeigt das Ersatzschaltbild einer Phasen-Spule mit einem Windungsschluss nach Fig. 4.

**Fig. 6** zeigt eine graphische Darstellung des relativen Teilkurzschluss/Windungsschlussstroms in Abhängigkeit von der Motorgeschwindigkeit eines PMSM.

**Fig. 7** zeigt eine graphische Darstellung des relativen Windungsschlussstroms in Abhängigkeit von der Prozentzahl der kurzgeschlossenen Windungen bezogen auf die Gesamtanzahl der Windungen in einem Wicklungsstrang eines PMSMs.

**Fig. 8** zeigt eine graphische Darstellung einer anfänglichen Heizrate der kurzgeschlossenen Windungen bei einem Windungsschluss eines PMSM.

**Fig. 9** zeigt eine graphische Darstellung einer relativen Heizrate der kurzgeschlossenen Windungen bei einem Windungsschluss eines PMSM.

**Fig. 10** zeigt ein vereinfachtes Ersatzschaltbild einer Phasenspule eines PMSM ohne Widerstand und ohne induzierte Spannungen im fehlerfreien Zustand.

**Fig. 11** zeigt ein vereinfachtes Ersatzschaltbild einer Phasenspule eines PMSM ohne Widerstand und ohne induzierte Spannungen mit einer kurzgeschlossenen sekundären Spulenwindung.

**Fig. 12** zeigt eine graphische Darstellung des Spannungsverlaufs über die Zeit.

**Fig. 13** zeigt eine das einphasige Ersatzschaltbild einer PMSM.

**Fig. 14** zeigt in drei graphischen Darstellungen den Verlauf der PWM-Spannung bei einer Pulsbreite von 50% sowie den Verlauf des Strom-Ripples für eine funktionierende Phase und den Strom-Ripple bei einem Windungsschluss in einer Phase der PMSM.

**Fig. 15** zeigt in drei graphischen Darstellungen die PWM-Spannung bei einer Pulsbreite von 25%, einen Strom-Ripple bei fehlerfreier Phase und einen Strom-Ripple bei einem Windungsschluss in einer Phase der PMSM .

**Fig. 16** zeigt eine schematische Darstellung des Ersatzschaltbildes für einen Elektromotor mit Drei-Phasen Sternpunkttopologie.

**Fig. 17** zeigt einen PWM-Spannungsverlauf bei einer Pulsbreite von 50% sowie den Strom-Ripple für eine funktionierende Phase und den Strom-Ripple für eine Phase mit Windungsschluss eines Sternpunktsystems nach Fig. 16.

**Fig. 18** zeigt einen PWM-Spannungsverlauf bei einer Pulsbreite von 25% sowie den Strom-Ripple für eine funktionierende Phase und den Strom-Ripple für eine Phase mit Windungsschluss eines Sternpunktsystems nach Fig. 16.

**Fig. 19** zeigt eine graphische Darstellung von Phasenströmen in funktionierenden Phasen in einem gesteuerten Servoantrieb für 3 x 3 Phasen mit Sternpunkttopologie.

**Fig. 20** zeigt eine graphische Darstellung der Phasenströme bei einem Fehler in einer Phase c in einem gesteuerten Servoantrieb für 3 x 3 Phasen mit Sternpunkttopologie.

**Fig. 21** zeigt eine graphische Darstellung der Phasenströme in funktionierenden Phasen in Vergrößerung in einem gesteuerten Servoantrieb für 3 x 3 Phasen mit Sternpunkttopologie.

**Fig. 22** zeigt die Phasenströme in Vergrößerung bei einem Fehler in Phase c in einem gesteuerten Servoantrieb für 3 x 3 Phasen mit Sternpunkttopologie.

**Fig. 23** zeigt eine schematische Darstellung eines Stromkreislaufs mit einer Drei-Phasen Sternpunkttopologie gemäß einem Ausführungsbeispiel der Erfindung.

**Fig. 24** zeigt eine schematische Darstellung einer Schaltung für ein Referenzpotential 4300 gemäß einem Ausführungsbeispiel der Erfindung.

**Fig. 25** zeigt graphische Darstellungen von Phasenströmen A bis I eines Beispielmotors mit zeitkontinuierlicher Spannungsversorgung gemäß einem Ausführungsbeispiel der Erfindung.

**Fig. 26** zeigt graphische Darstellungen der Fehlerspannungen der Sternpunkte (=Potentialdifferenz zwischen Sternpunkt- und Referenzpotential) eines Beispielmotors mit zeitkontinuierlicher Spannungsversorgung gemäß einem Ausführungsbeispiel der Erfindung.

**Fig. 27** zeigt drei graphische Darstellungen für die drei Ansteuerspannungen U1, U2 und U3 eines Sternpunktsystems eines Beispielmotors mit einem Teilkurzschlussfehler und eine grafische Darstellung für das Sternpunktpotential des zugehörigen Sternpunktes bei schaltender PWM-Spannungsversorgung und das betreffende Referenzpotential gemäß einem Ausführungsbeispiel der Erfindung.

**Fig. 28** zeigt in drei graphischen Darstellungen den ungefilterten Zeitverlauf der Fehlerspannungen der Sternpunkte bei schaltender PWM-Spannungsversorgung gemäß einem Ausführungsbeispiel der Erfindung.

**Fig. 29** zeigt in drei graphischen Darstellungen den ungefilterten Zeitverlauf der Fehlerspannungen der Sternpunkte bei schaltender PWM-Spannungsversorgung in einer Zoom-Darstellung gemäß einem Ausführungsbeispiel der Erfindung.

**Fig. 30** zeigt in drei graphischen Darstellungen den gefilterten Verlauf der Fehlerspannungen der Sternpunkte eines PMSM bei schaltender PWM-Spannungsversorgung gemäß einem Ausführungsbeispiel der Erfindung.

**Fig. 31** zeigt in drei graphischen Darstellungen den gefilterten Verlauf der Fehlerspannungen der Sternpunkte eines PMSM bei geringer Drehzahl gemäß einem Ausführungsbeispiel der Erfindung.

**Fig. 32** zeigt eine schematische Darstellung eines Ansteuerverfahrens zur Fehlerdetektion bei geringer Motordrehzahl für einen PMSM mit Sternpunkttopologie gemäß einem Ausführungsbeispiel der Erfindung.

**Fig. 33** zeigt in drei graphischen Darstellungen den gefilterten Verlauf der Fehlerspannungen der Sternpunkte bei geringer Motordrehzahl und Verwendung des Ansteuerverfahrens aus Fig. 32 zur Fehlerdetektion gemäß einem Ausführungsbeispiel der Erfindung.

**Fig. 34** zeigt in drei graphischen Darstellungen Phasenströme mit überlagerten höherfrequenten Blindstromanteilen für die Phasen eines PMSMs gemäß einem Ausführungsbeispiel der Erfindung.

**Fig. 35** zeigt in drei graphischen Darstellungen die Phasenströme ohne überlagerte höherfrequente Blindstromanteile für die Phasenströme eines PMSM gemäß einem Ausführungsbeispiel der Erfindung.

**Fig. 36** zeigt eine schematische Darstellung einer Detektions- und Steuervorrichtung gemäß einem Ausführungsbeispiel der Erfindung.

**Fig. 37** zeigt eine schematische Aufsicht eines Luftfahrzeugs mit mehreren Detektions- und Steuervorrichtungen gemäß einem Ausführungsbeispiel der Erfindung.

**Fig. 38** zeigt ein Flussdiagramm eines Verfahrens gemäß einem Ausführungsbeispiel der Erfindung.

### Detaillierte Beschreibung von beispielhaften Ausführungsformen

Im Folgenden werden unter Bezugnahme auf die beigefügten Zeichnungen Ausführungsbeispiele der Erfindung beschrieben.

Die Darstellungen in den Figuren sind schematisch und nicht maßstäblich. In den folgenden Figurenbeschreibungen werden zumeist für gleiche oder ähnliche Elemente die gleichen Bezugszeichen verwendet.

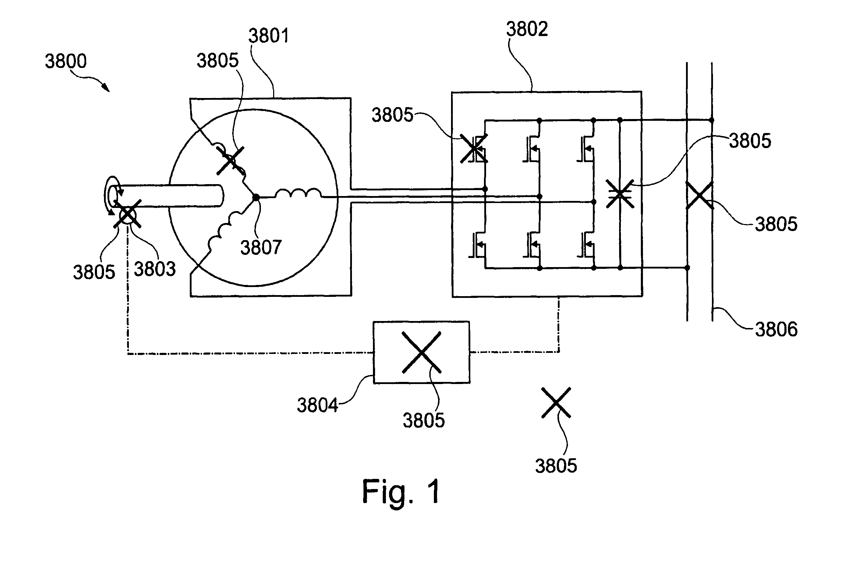

Fig. 1 zeigt einen Standard PMSM-Antrieb 3800 mit mehreren Fehlerszenarien 3805 in der Statorwicklung eines Motors mit Sternpunkttopologie 3801 mit einem Sternpunkt 3807, in einem Winkelgeber 3803, der an der Antriebswelle des Motors 3801 angeordnet ist, im Zwischenkreiskondensator sowie in einem Schalterelement eines Verstärkers mit Halbbrücke 3802, der mit dem Motor 3801 über mehrere Leitungen an den Spulen des Motors 3801 angeschlossen ist, in einem DC (Gleichspannungs)-Bus 3806 und in einem Steuercomputer 3804, der über Leitungen an den Winkelgeber 3803 und den Verstärker mit Halbbrücke 3802 angeschlossen ist.

Jeder Fehler einer elektrischen Komponente führt zu einem Verlust des Antriebs. Die Verfügbarkeit des Antriebs wird durch die Implementierung von entsprechenden redundanten Komponenten verbessert.

Eine geeignete Antriebstopologie soll sicherstellen, dass ein einzelner (elektrischer) Fehler nicht zum Ausfall des gesamten Antriebs führt, sondern der Antrieb auch im Fehlerfall (gegebenenfalls mit reduzierter Performance) seine Aufgabe erfüllen kann.

Grundsätzlich kommen eine ganze Reihe unterschiedlicher Topologien für fehlertolerante Antriebe in Frage. Entscheidend ist dabei jeweils, dass das bei Ausfall eines Teilsystems (zum Beispiel eines Strangs) verbleibende Restsystem in der Lage ist, das benötigte Drehmoment (bei gegebener Drehzahl) aufzubringen, ohne dass dabei das ausgefallene Teilsystem oder das verbleibende Restsystem thermisch überlastet wird.

Naturgemäß ist diese Forderung bei einer hohen Zahl von Teilsystemen leichter zu erfüllen. Andererseits steigt mit der Anzahl der Teilsysteme die Komplexität und die Fehlerwahrscheinlichkeit, wenn man von gleicher mechanischer Leistung im ungestörten Betrieb ausgeht.

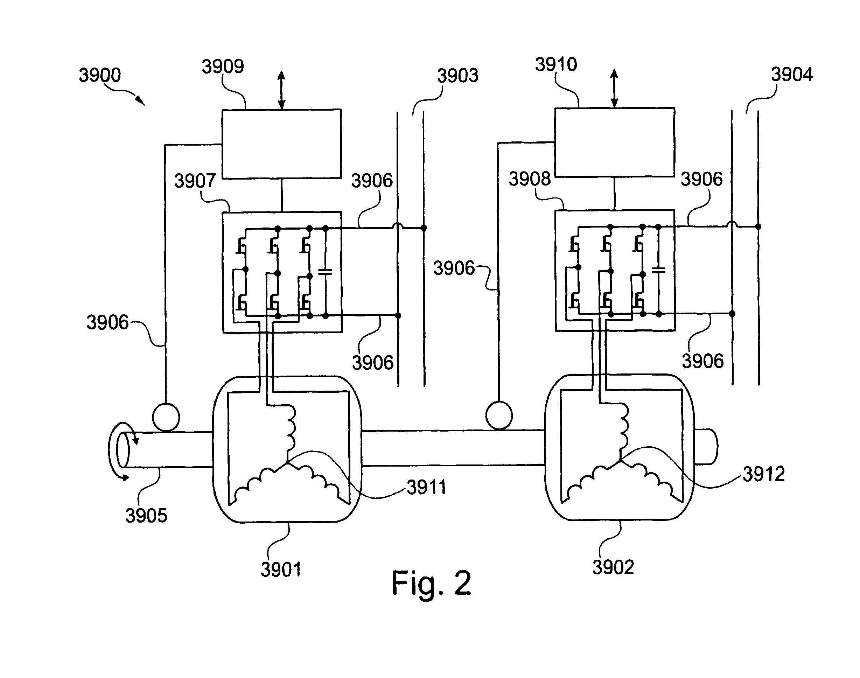

Fig. 2 zeigt einen Antrieb mit mehreren Drehmoment addierenden PMSMs 3900, die für niedrige Kurzschluss-Ströme und Kurzschluss-Drehmomente ausgeführt sind.

Eine Antriebswelle 3905 wird von zwei PMSMs 3901, 3902 mit jeweils einem Sternpunkt 3911, 3912 angetrieben. An der Welle 3905 ist neben den Motoren 3901, 3902 jeweils eine Winkelgeber zum Messen der Winkelposition und Drehgeschwindigkeit der Welle 3905 angeordnet. Jeder Motor 3901, 3902 ist über Leitungen an einem Verstärker mit Halbbrücke 3907, 3908 angeschlossen. Die beiden Verstärker 3907, 3908 sorgen für den Antrieb des Motors und sind über Leitungen 3906 an jeweils einem DC-Bus 3903, 3904 sowie einer Steuerungs/Regelungs-Einheit (Motor Control Module MCM) 3909, 3910 angeschlossen. Jede MCM-Einheit 3909, 3810 ist über eine Leitung 3906 an jeweils einen Winkelgeber angeschlossen und überwacht und/oder steuert den Zustand des entsprechenden Motors 3901, 3902.

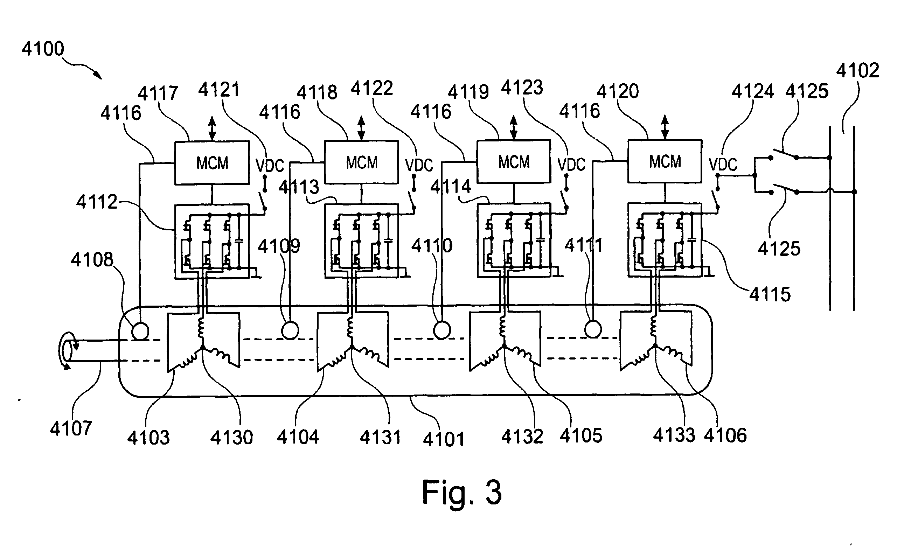

Fig. 3 zeigt einen intern redundanten Antrieb mit multi-Sternpunkt-Topologie 4100 und einer physikalischen Isolation der Sternpunkte. In Fig. 3 wird eine Antriebswelle 4107 mit einer Antriebseinheit 4101 dargestellt. Die Antriebseinheit 4101 ist ein intern redundanter PMSM dessen Statorwicklungen zu mehreren (N>1) Sternpunktgruppen 4103, 4104, 4105, 4106 mit jeweils einem Sternpunkt 4130, 4131,4132,4133 mit jeweils 3 Anschlussklemmen verschaltet sind, die über Leitungen an gleich viele Verstärker mit Halbbrücken 4112, 4113, 4114, 4115 5 angeschlossen sind. An der Welle sind M>1 (im Beispiel M=4) redundante Winkelgeber 4108, 4109, 4110, 4111 angeordnet, die die Winkelposition und Geschwindigkeit der Welle 4107 messen und über Leitungen 4116 oder eine zwischengeschaltete Sensorauswerteeinheit geeignet an L> 1 (im Beispiel L=M=4) MCMs 4117, 4118, 4119, 4120 angeschlossen sind, die zum Beobachten bzw. Steuern des Zustands eines Teiles oder aller Sternpunktsysteme 4103, 4104, 4105, 4106 ausgeführt sind und jeweils an die entsprechenden Verstärker mit Halbbrücke 4112, 4113, 4114, 4115 angeschlossen sind.

Jeder Verstärker mit Halbbrücke 4112, 4113, 4114, 4115 ist über einen oder mehrere Trennschalter an eine oder mehrere Gleichstromquellen VDC 4121, 4122, 4123, 4124 angeschlossen, und sorgt für die Versorgung der Spulen der Motoren 4103, 4104, 4105, 4106 mit Strom. Die Gleichstromquellen VDC sind über Leitungen und Schaltern 4125 an DC-Netzen 4102 angeschlossen. Ein derartiger Antrieb mit mehreren Verstärkern und Motoren mit multi-Sternpunkt-Topologie ermöglicht es, dass bei einem erkannten Motorfehler kein Drehmoment-Ripple auftritt.

Mögliche Ansätze zur fehlertoleranten Ausführung von PMSM Antrieben sind eine Duplizierung der Antriebe (Fig. 2) sowie intern redundante Motorkonzepte (z.B. Fig. 3). Bei intern redundanten Motorkonzepten wird das elektromagnetische System in weitgehend autonome Teilsysteme (einzelne Phasen oder Gruppen aus mehreren Phasen) zerlegt. Der Vorteil der internen Redundanz besteht in der Regel in der Einsparung von Gewicht und Bauraum.

Für intern redundante Konzepte existieren bestimmte Anforderungen, um den Betrieb nach Auftreten eines Fehlers zu gewährleisten. Bei Ausfall eines Teilsystems (Motor oder Leistungselektronik) muss das verbleibende System in der Lage sein, das geforderte Drehmoment ohne thermische Überlastung des ausgefallenen oder des verbleibenden Teilsystems aufzubringen. Die Wirkung des Fehlers muss auf das betroffene Teilsystem beschränkt bleiben. Strategien zur Entkopplung sowohl des elektromagnetischen Systems als auch der zugeordneten Module der Leistungselektronik sind zwingend erforderlich. Es gibt Fälle (insbesondere bei einem Teilkurzschluss oder Windungsschluss eines Wicklungsstrangs), in denen das Steuergerät des Motors im Fehlerfall das betroffene Teilsystem aktiv abschalten muss. In diesen Fällen ist die Fehlererkennung durch das Steuergerät erforderlich.

Eine Begrenzung von Kurzschlussströmen erfolgt durch eine möglichst hohe Selbstinduktivität der Wicklungsstränge. Hierdurch kann auch das Kurzschluss-Bremsmoment (Drehmoment-Ripple) auf einen kleinen Wert reduziert werden. Diese "implizite" Begrenzung des Kurzschluss-Stroms kann durch konstruktive Maßnahmen im Motordesign erzielt werden. Hierzu muss die Streuinduktivität künstlich erhöht werden. Die Streuinduktivität kann beispielsweise durch die Weite und Tiefe der Nutöffnung eingestellt werden. Der Nachteil einer hohen Streuinduktivität ist allerdings ein erhöhter Spannungsbedarf.

Im Falle eines Windungsschlusses ist dieser zu erkennen und der gesamte Strang kurzzuschließen, um den auftretenden maximalen Kurzschlussstrom zu begrenzen. Andernfalls tritt eine lokale thermische Überlastung der Wicklung auf, die den gesamten Strang zerstören und dessen ("implizite") Strombegrenzung aufgeben kann.

Sicherheitskritische Anwendungen wie beispielsweise elektrisch betätigte Steuer- oder Hochauftriebsflächen (Querruder, Landeklappen...) eines Flugzeugs sind auf redundante und/oder fehlertolerante elektrische Antriebe angewiesen. Redundante und/oder fehlertolerante permanenterregte elektrische Synchronmaschinen liefern nach Stand der Technik die höchste Leistungsdichte also das geringste Antriebsgewicht. Trotz kurzgeschlossener Windungen oder Spulen in einzelnen Phasen oder Phasengruppen des PMSM, muss der Antrieb weiterlaufen können. Typischerweise haben diese permanenterregten elektrischen Maschinen redundante Wicklungen, in denen eine physikalische und elektromagnetische Trennung von Spulen, die sich um abwechselnde Ankerzähne winden, realisiert ist.

Für fehlertolerante elektrische Maschinen existiert eine grundsätzliche Anforderung für eine normierte Ankerreaktanz von etwa 1,0 . Somit ist der Kurzschlussstrom und die Verlustleistung einer kurzgeschlossenen Spule sogar bei maximaler Motorgeschwindigkeit auf einen tolerierbaren Wert begrenzt.

Zusätzlich zu dem Kurzschlussversagen an den Phasen-Klemmen, sollten permanenerregte Maschinen mit redundanten Wicklungen tolerant gegenüber Kurzschlüssen in einer oder mehreren Windungen sein (Teilkurzschluss). In diesem Fall verhindert die hohe Gesamtankerreaktanz allerdings nicht eine exzessiv hohe Strom- und Hitzeentwicklungen in den kurzgeschlossenen Windungen.

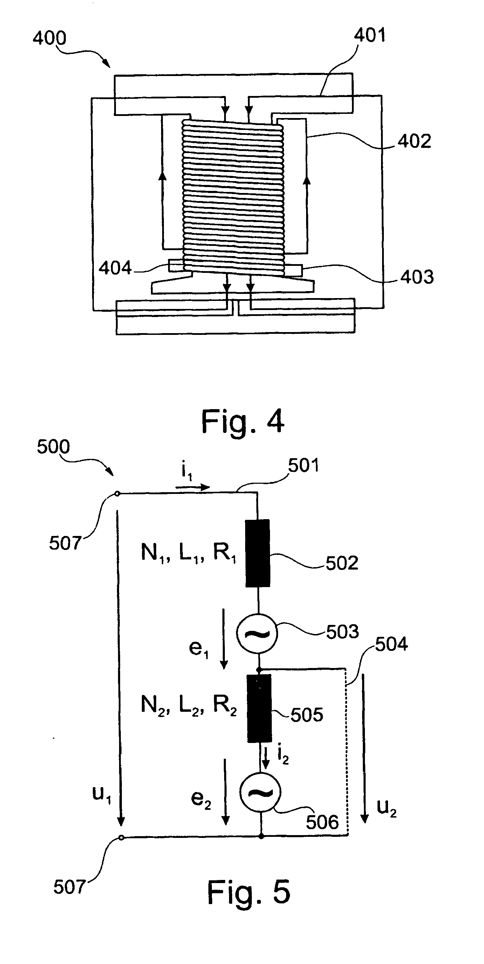

Fig. 4 zeigt schematisch einen Teilkurzschluss in einer 1-Phasen-Spule 400 mit einem Statorzahn eines Elektromotors, einer Spulenwicklung und einem Rotor, der im unteren Abschnitt der Fig. 3 dem Anker gegenüberliegend angeordnet ist. Die Spule ist derart ausgeführt, dass eine magnetische Flussverkettung aller Spulenwindungen 401 vorhanden ist. In einem oberen Abschnitt der Spule sind $N_1$ "funktionierende" Spulenwindungen mit dem Streufluss 402 angeordnet. In einem unteren Abschnitt der Spule sind $N_2$ "kurzgeschlossene" Spulenwindungen mit dem Streufluss 403 vorhanden. Im unteren Bereich der Spule liegt ein Kurzschluss zwischen Spulenwindungen 404 vor. In der Formel

$$x = \frac{N_2}{N_1}$$

beschreibt der Parameter x das Verhältnis zwischen der Anzahl kurzgeschlossener Windungen $N_2$ und der Anzahl "funktionierender" Spulenwindungen $N_1$.

Fig. 5 zeigt ein Ersatzschaltbild 500 des in Fig. 4 dargestellten und oben beschriebenen Teilsystems.

Die in Fig. 5 genannten Bezugszeichen sind im Folgenden erörtert:

$u_1$:           Phasen-Klemmen Spannung
$i_1$:            Phasen-Klemmen Strom
$e_1$:           Induzierte Spannung in "funktionierenden" Spulenwindungen
$L_1, R_1$:    Selbstinduktivität und Widerstand der "funktionierenden" Spulenwindungen
$u_2=0$:     Kurzschlussspannung (null)
$i_2$:            Teilkurzschlussstrom
$e_2$:           Induzierte Spannung in "kurzgeschlossenen" Spulenwindungen
$L_2, R_2$:    Selbstinduktivität und Widerstand der "kurzgeschlossenen" Spulen

Das Ersatzschaltbild der Fig. 5 weist eine "funktionierende" Spulenwicklungseinheit 502 mit einer Anzahl von funktionierenden Windungen $N_1$, einer Selbstinduktivität $L_1$ und einem Widerstand $R_1$ auf, die über eine Leitung 501 an einer Spannungsquelle 507 angeschlossen ist und eine induzierte Spannung $e_1$, 503 aufweist. Der Analogstromkreis weist weiterhin einen Spulenwicklungsabschnitt 505 mit einer Anzahl von kurzgeschlossenen Windungen $N_2$ (Kurzschlusspfad: 504), einer Selbstinduktivität $L_2$ und einem Widerstand $R_2$ auf, und eine induzierte Spannung $e_2$, 506.

Durch die funktionierende Spuleneinheit 502 fließt ein Phasenanschlussstrom $I_1$, durch die "kurzgeschlossene" Spulenwindungseinheit 505 fließt ein Windungsschlussstrom $I_2$. Die Spannungsquelle 507 versorgt den Stromkreis mit einer Phasenanschlussspannung von $u_1$. An der kurzgeschlossenen Spulenwindungseinheit herrscht eine Kurzschlussspannung $u_2$ von 0 Volt.

Im Folgenden sind Gleichungen für die Ströme in den beiden Abschnitten der Spule dargestellt:

Funktionierender Spulenabschnitt:

$$R_1 \cdot i_1 + L_1 \frac{di_1}{dt} + M \frac{di_2}{dt} = u_1(t) - e_1(t)$$

Kurzgeschlossener Spulenabschnitt:

$$R_2 \cdot i_2 + M \frac{di_1}{dt} + L_2 \frac{di_2}{dt} = u_2(t) - e_2(t) = -e_2(t)$$

L    Gesamtinduktivität der Phase
R    Gesamtwiderstand der Phase
e(t)    Gesamte induzierte Spannung der Phase

$$k = \frac{L - L_S}{L}$$     Kopplungskoeffizient ($L_s$=Streuinduktivität)

$$x = \frac{N_2}{N_1}$$     Spulenwindungsverhältnis von kurzgeschlossenen zu funktionierenden Spulenwindungen

Bei entsprechendem Ersetzen der Parameter ergibt sich folgender Zusammenhang:

$$L_1 = L \cdot (1-x)^2 \quad R_1 = R \cdot (1-x) \quad e_1(t) = e(t) \cdot (1-x)$$
$$L_2 = L \cdot x^2 \quad\quad R_2 = R \cdot x \quad\quad e_2(t) = e(t) \cdot x$$

Das Auftreten eines Motorfehlers kann besser verstanden werden, wenn der folgende Fall angenommen wird:

- die Phasenspule hat offene Klemmen 507 ($i_1$=0)
- der Windungsschluss mit $N_2$=x * $N_1$ beschränkt sich auf einen kleinen Teil der Phasenspule (x<<1).

Dann gilt:

$$M = k \cdot \sqrt{L_1 \cdot L_2} = k \cdot L \cdot x \cdot (1 - x) \approx k \cdot L \cdot x$$

Unter der Annahine, dass die sinusförmige induzierte Spannung

$$e(t) = \hat{E} \cdot \cos(\omega_{el} t) = \sqrt{2} \cdot \omega_M \cdot \frac{k_T}{m} \cdot \cos(\omega_{el} t)$$

mit

$k_T$:    Drehmomentkonstante des Motors
$m$:    Anzahl der Phasen
$\omega_M$:    Winkelgeschwindigkeit des Motors
$\omega_{el}$:    Winkelfrequenz des Motors ($\omega_{el}$ = ppz x $\omega_M$)

ist der Windungsschlussstrom (rms-Wert):

$$I_2 = \frac{E_2}{\sqrt{(\omega_{el} \cdot L_2)^2 + R_2^2}} = \omega_M \cdot \frac{k_T}{m} \cdot \frac{x}{\sqrt{(\omega_{el} \cdot x^2 \cdot L)^2 + (x \cdot R)^2}} = \frac{1}{m} \cdot \frac{\omega_M \cdot k_T}{\sqrt{(\omega_{el} \cdot x \cdot L)^2 + R^2}}$$

Bei einem Teilkurzschluss ist der resultierende Kurzschlussstrom in dem kurzgeschlossenen Teil der Wicklung um ein Vielfaches größer als der Nenn-Stromwert. Aufgrund der geringen Induktivität der Teilwicklung (L$_2$=x$^2$•L), wird der Kurzschlussstrom nur durch den ohmschen Anteil des Wicklungswiderstandes begrenzt.

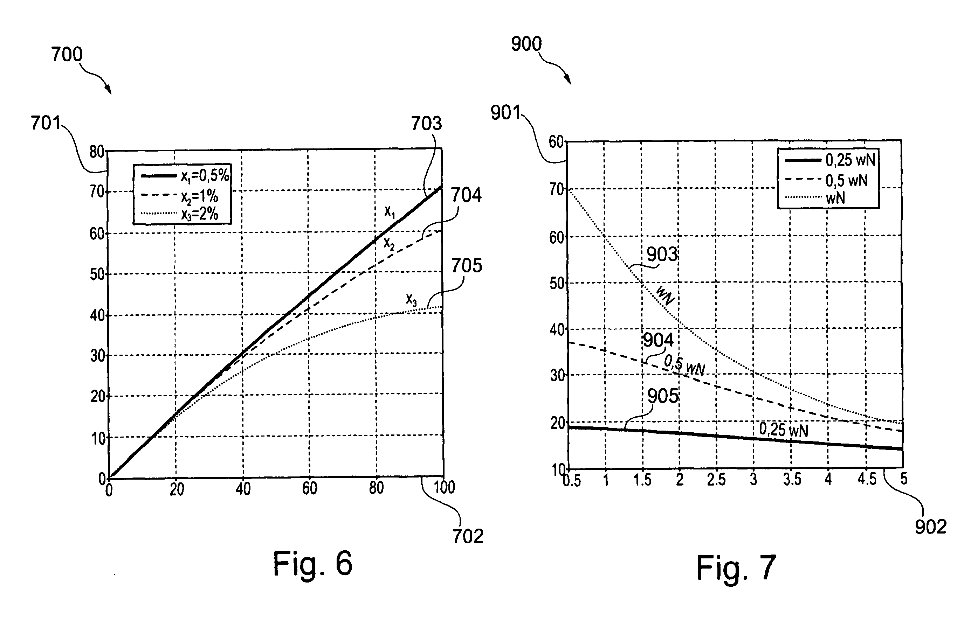

Fig. 6 zeigt eine graphische Darstellung des relativen Windungsschlussstroms 700 in einem PMSM (permanent erregter Elektromotor). Die Bezugsgröße ist der Kurzschlussstrom für den Fall, dass die gesamte Wicklung an den Klemmen kurzgeschlossen ist, mit einer vertikalen Achse, die den relativen Kurzschlussstrom von Faktor 0 bis 80 anzeigt 701 und einer horizontalen Achse, die die Motorgeschwindigkeit in Bezug zur Nenngeschwindigkeit in Prozent von 0 bis 100 % 702 darstellt. Der Graph 703 zeigt den Stromfluss bei einem Verhältnis x$_1$ von kurzgeschlossenen Windungen zu funktionierenden Windungen von 0,5 %. Der Graph 704 zeigt den Stromfluss bei einem Verhältnis x$_2$ von kurzgeschlossenen Windungen zu den funktionierenden Windungen von 1 %. Der Graph 705 zeigt den Stromfluss bei einem Verhältnisses x$_3$ von kurzgeschlossenen Windungen zu funktionierenden Windungen von 2 %. Das Beispiel zeigt, dass der lokale Kurzschlussstrom I$_2$ bei Windungsschluss um den Faktor 70 über dem "normalen" Kurzschlussstrom liegen kann.

Die Parameter des des Fig. 6 zugrunde liegenden Antriebes sind die folgenden:

| | |
|---|---|
| m = 9: | Anzahl der Spulen (3x3) |
| ω$_N$ = 133 x 2 x ρ: | 8000 rpm |
| ppz = 7: | 14 - poliger Motor |
| r = 0,06: | gesamter Spulenwiderstand (Ω) |
| L = 0,0077: | gesamte Spuleninduktivität (Henry) |
| Kt = 0,62: | Drehmomentkonstante (Nm/A) |

Die oben genannten Parameter gelten ebenfalls für die folgenden Fig. 7, 8 und 9.

Fig. 7 zeigt den relativen Teilkurzschlussstrom in Abhängigkeit von der Prozentzahl der kurzgeschlossenen Windungen bezogen auf die Gesamtanzahl der Windungen in der Spule eines PMSMs 900 mit einer vertikalen Achse, die den relativen Strom bezogen auf den "normalen" Kurzschlussstrom anzeigt und einer horizontalen Achse, die das Verhältnis der kurzgeschlossenen Windungen mit Bezug auf die Gesamtanzahl der Windungen in Prozent von 902 von 0,5 bis 5 % anzeigt. Der Graph 903 zeigt den Stromfluss für eine Nenndrehzahl von 1 wN. Der Graph 904 zeigt den Stromfluss für halbe Nenndrehzahl von 0,5 wN. Der Graph 905 zeigt den Stromfluss für eine Drehzahl von 0,25 wN.

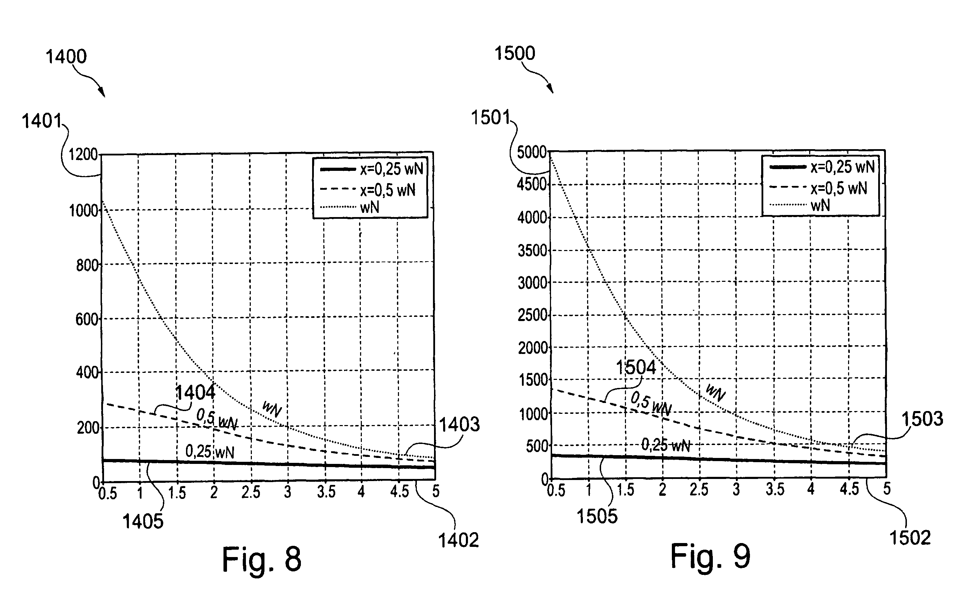

Fig. 8 zeigt die anfängliche Heizrate der kurzgeschlossenen Windungen bei einem Windungsschluss eines PMSM 1400 mit einer vertikalen Achse 1401, die die Heizrate von 0 bis 1200 K/s anzeigt, und einer horizontalen Achse, die die Prozentzahl der kurzgeschlossenen Windungen im Verhältnis zur Gesamtanzahl der Windungen der Spule von 0,5 bis 5 % anzeigt. Der Graph 1403 zeigt die Heizrate bei einer Drehzahl von 1 wN. Der Graph 1404. zeigt die Heizrate bei einer Drehzahl von 0,5 wN. Der Graph 1405 zeigt die Heizrate bei einer Drehzahl von 0,25 wN.

Fig. 9 zeigt die relative anfängliche Heizrate der kurzgeschlossenen Windungen bei einem Windungsschluss eines PMSM 1500 mit einer vertikalen Achse 1501, die die relative Heizrate anzeigt und einer horizontalen Achse 1502, die die Prozentzahl der kurzgeschlossenen Windungen im Verhältnis zur Gesamtanzahl der Windungen der Spule von 0,5 bis 5 % anzeigt. Bezugsgröße für die relative Heizrate ist die anfängliche Heizrate im Falle eines "normalen" Kurzschlusses an den Klemmen. Der Graph 1503 zeigt die Heizrate bei einer Drehzahl von 1 wN. Der Graph 1504 zeigt die Heizrate bei einer Drehzahl von 0,5 wN. Der Graph 1505 zeigt die Heizrate bei einer Drehzahl von 0,25 wN.

Die exzessive Wärmemenge, die sich in den kurzgeschlossenen Windungen entwickelt, kann die Isolationsschicht beschädigen oder sogar das Leitermaterial lokal aufschmelzen. Eine Fehlerausbreitung wird mit hoher Wahrscheinlichkeit stattfinden.

Die Früherkennung eines Teilkurzschlusses in Windungen ist demnach wesentlich, um Fehlerbehebungsstrategien einzuleiten, bevor der Fehler sich ausgebreitet hat und möglicherweise andere Phasen-Spulen oder Motorbauteile beschädigt hat.

Ein Kurzschluss muss sofort detektiert werden und die Klemmen des betreffenden Teilsystems müssen kurzgeschlossen werden. Dies kann einfach durch das Schließen der zugehörigen "low side" Halbleiterschalter des Leistungswandlers (Verstärkers) erreicht werden.

Der Kurzschlussstrom wird auf einen unkritischen nominalen Kurzschlussstrom des Teilsystems begrenzt. Alle Windungen der Spule, nicht nur eine kleine Prozentzahl, leisten Ihren Beitrag zu der gesamten magnetomotorischen Kraft der Spule.

$$I_{K2} = \frac{E}{\sqrt{(\omega_{el} \cdot x \cdot L)^2 + R^2}} \qquad \Longrightarrow \qquad I_K = \frac{E}{\sqrt{(\omega_{el} \cdot L)^2 + R^2}} \qquad E = \omega_M \cdot \frac{k_T}{m}$$

Die schnelle und sichere Detektion eines Teilkurzschlusses/ Windungskurzschlusses ist nicht einfach. Der Klemmenstrom, der im Verstärker messbar ist, ändert sich nicht signifikant bei einem Teilkurzschluss/Windungskurzschluss.

Detektionsmethoden können auf der Änderung der Selbstinduktivität der fehlerhaften Spule basieren die über die Klemmenstromwellenformen und insbesondere über den Strom-Ripple erkannt werden kann.

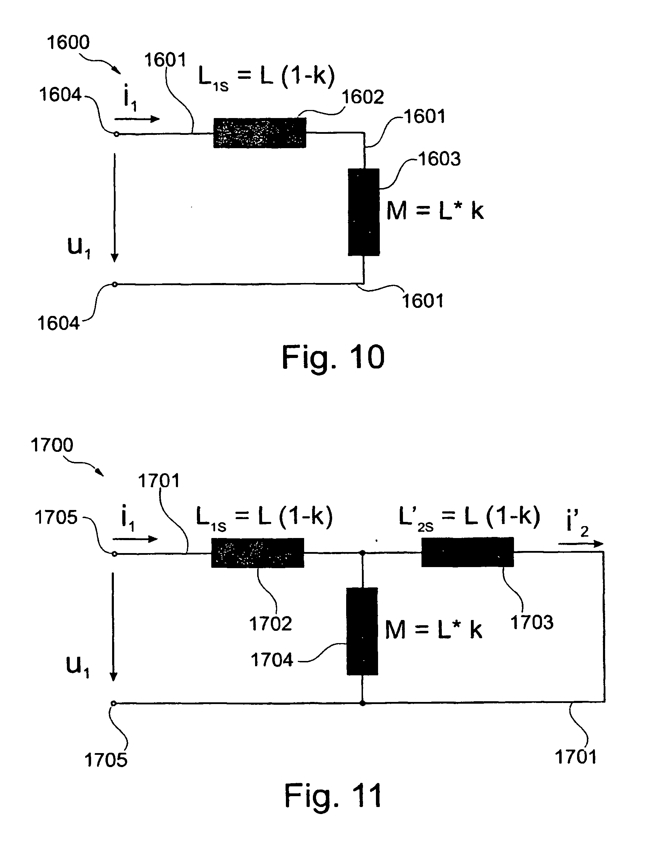

Fig. 10 und Fig. 11 zeigen jeweils einen vereinfachtes Ersatzschaltbild einer Phasenspule eines PMSM ohne Widerstand und ohne induzierte Spannungen die zur Betrachtung des Teilkurzschlussfehlers ($x=N_2/N_1 \ll 1$) in zwei Teilwicklungen mit Selbstinduktivitäten und einer Koppelinduktivität aufgeteilt ist (vgl. auch Fig. 4). Die Situation ist äquivalent zu einem Transformator mit Primär- und Sekundärwicklung, bei dem die Windungszahl der Sekundärwicklung sehr viel kleiner als die der Primärwicklung ist und wobei bei Fig. 10 die Klemmen der Sekundärwicklung offen und bei Fig. 11 kurzgeschlossenen sind.

Für einen funktionierenden Zustand (Fig. 10) gilt, dass die Spuleninduktivität L1 etwa gleich der an den Klemmen 1604 messbaren Gesamtinduktivität der Phase L ist. Fig. 10 zeigt einen Stromkreis bei einem funktionierenden Zustand der Spule 1600 mit Klemmen 1604, an denen eine Spannung $u_1$ anliegt, und durch die ein Strom $i_1$ fließt. Das Ersatzschaltbild enthält eine Streuinduktivität $L_{1S} = L \cdot (1-k)$ (k = Kopplungskoeffizient) der Primärwicklung 1602 und eine Koppelinduktivität $M = L \cdot k$ 1603 auf.

Fig. 11 stellt den Fall einer Phasenspule mit Windungskurzschluss dar 1700, mit einer Spannungsquelle $u_1$ 1705, sowie einer primärseitigen Streuinduktivität $L_{1S}=L \cdot (1-k)$ 1702 (Streuinduktivität des intakten Wicklungsabschnittes), einer sekundärseitigen Streuinduktivität $L'_{2S}=L \cdot (1-k)$ 1703 (Streuinduktivität des kurzgeschlossenen Wicklungsabschnittes) und einer Koppelinduktivität $M=L \cdot k$ 1704.

Die an den Klemmen 1604 bzw. 1705 messbare Gesamtinduktivität L ändert sich mit dem Auftreten des Fehlers. Die Änderung der Gesamtinduktivität im Fehlerfall hängt von dem Kopplungskoeffizient k der zwei Teilwicklungen ab:

$$L_{\text{funktionierend}} / L_{\text{defekt}} = 1\text{-}k^2$$

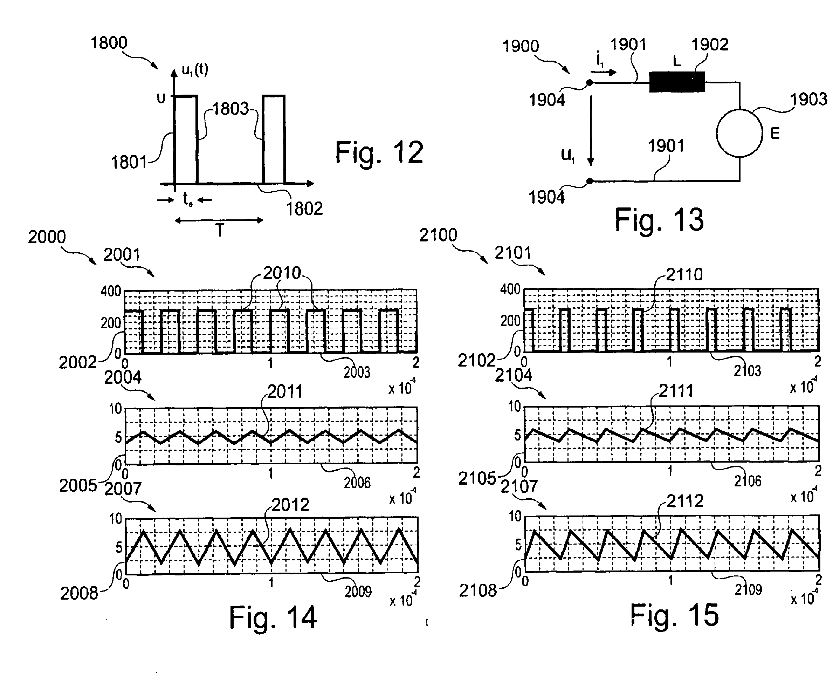

Fig. 12 zeigt den prinzipiellen Spannungsverlauf über die Zeit bei Speisung eines Motorstrangs 1800 mit einer PWM-Endstufe. Die graphische Darstellung gemäß Fig. 12 weist eine vertikale Achse 1801 zum Anzeigen der Spannung U auf und weist eine horizontale Achse 1802 zum Anzeigen der Zeit T auf. Der Graph 1803 zeigt einen pulsförmigen Spannungsverlauf über die Zeit $u_1$ (t) mit einer Pulsdauer von $t_e$.

Fig. 13 zeigt ein vereinfachtes Ersatzschaltbild des besagten Motorstranges. Fig. 13 weist eine Spannungsquelle 1904 mit einer Spannung $u_1$ auf, sowie eine Induktivität L 1902, die über Leitungen 1901 an der Spannungsquelle 1904 angeschlossen ist und eine induzierte Spannung E 1903. Für den Stromkreis gemäß Fig. 13, angesteuert mit einem Spannungsverlauf wie in Fig. 12 dargestellt gelten folgende formeltechnischen Zusammenhängt:

PWM Arbeitszyklus:

$$\tau_e = \frac{t_e}{T}$$

induzierte Spannung (EMF):

$$E = \tau_e \cdot U$$

Strom-Ripple (funktionierend):

$$\Delta i = \frac{U \cdot T}{L} \cdot \tau_e \cdot (1 - \tau_e)$$

Strom-Ripple (fehlerhaft):

$$\Delta i = \frac{U \cdot T}{L \cdot (1 - k^2)} \cdot \tau_e \cdot (1 - \tau_e)$$

Der Strom-Ripple vergrößert sich also im Fehlerfall um den Faktor

$$\frac{1}{1-k^2}$$

Fig. 14 zeigt den Verlauf der PWM-Spannung für einen Arbeitszyklus von 50% sowie den Verlauf des Strom-Ripples für einen funktionierenden Stromkreis und den Strom-Ripple bei einem Windungsschluss in einem PMSM 2000. Die graphische Darstellung 2001 mit einer vertikalen Achse 2002, die eine Spannung von 0 bis 400 Volt anzeigt und eine horizontalen Achse 2003, die die Zeit von 0 bis 2 x 10$^{-4}$ Sekunden anzeigt beschreibt die PWM-Spannung für einen Arbeitszyklus von 50 % in Abhängigkeit von der Zeit 2010. Die graphische Darstellung 2004 mit einer vertikalen Achse 2005, die den Strom von 0 bis 10 Ampere anzeigt und einer horizontalen Zeitachse 2006 gemäß der Zeitachse 2003 zeigt den Strom-Ripple in Abhängigkeit von der Zeit bei einem funktionierenden Stromkreis 2011. Die graphische Darstellung 2007 zeigt eine vertikale Achse 2008, die den Strom in Ampere gemäß der vertikalen Achse 2005 anzeigt und einer horizontalen Zeitachse 2009 gemäß der Zeitachse 2006 zeigt den vergrößerten Strom-Ripple bei einem Windungsschluss in Abhängigkeit von der Zeit 2012.

Fig. 15 zeigt eine PWM-Spannung für einen Arbeitszyklus von 25%, einen Strom-Ripple bei fehlerfreiem Verhalten des Stromkreises und einen Strom-Ripple bei einem Windungsschluss eines PMSM im Verhältnis zum Zeitablauf 2100. Die graphische Darstellung 2101 mit einer vertikalen Achse 2102, die den Spannungsverlauf von 0 bis 400 Volt anzeigt, und einer horizontalen Achse 2103, die den Zeitverlauf von 0 bis 2 x 10$^{-4}$ Sekunden anzeigt, beschreibt die PWM-Spannung für einen Arbeitszyklus von 25 % über die Zeit 2110. Die graphische Darstellung 2104 mit einer vertikalen Achse 2105, die den Stromverlauf von 0 bis 10 Ampere anzeigt, und einer horizontalen Zeitachse 2106 gemäß der Zeitachse 2103 zeigt einen Strom-Ripple bei einem funktionierenden Stromkreis über die Zeit 2111. Die graphische Darstellung 2107 zeigt eine vertikale Achse 2108, die den Stromverlauf gemäß der vertikalen Achse 2105 anzeigt, und eine horizontale Zeitachse 2109 gemäß der Zeitachse 2106, zeigt den vergrößerten Strom-Ripple bei einem Windungsschluss über die Zeit 2112.

Teilwindungskurzschlüsse könnten also bei separater PWM-Ansteuerung der einzelnen Phasen prinzipiell durch das Beobachten des Strom-Ripple, der aus der PWM-Spannungsschaltung resultiert, detektiert werden.

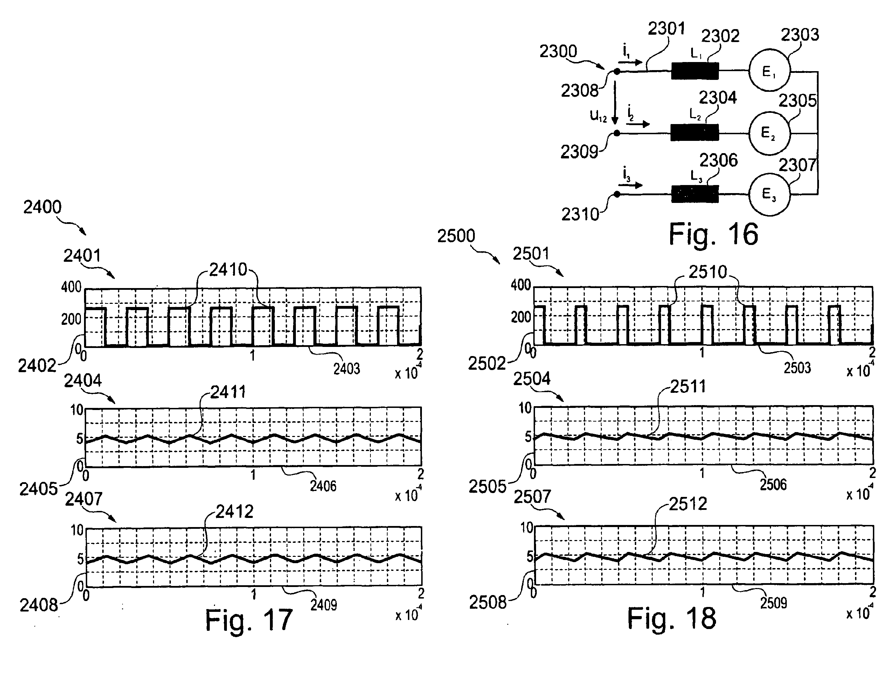

Die Auswertung des Strom-Ripple ist aber für Motoren mit Drei-Phasen Sternpunkttopologie nicht praktikabel, wie im folgenden Abschnitt gezeigt wird (Fig. 16, 25 und 26).

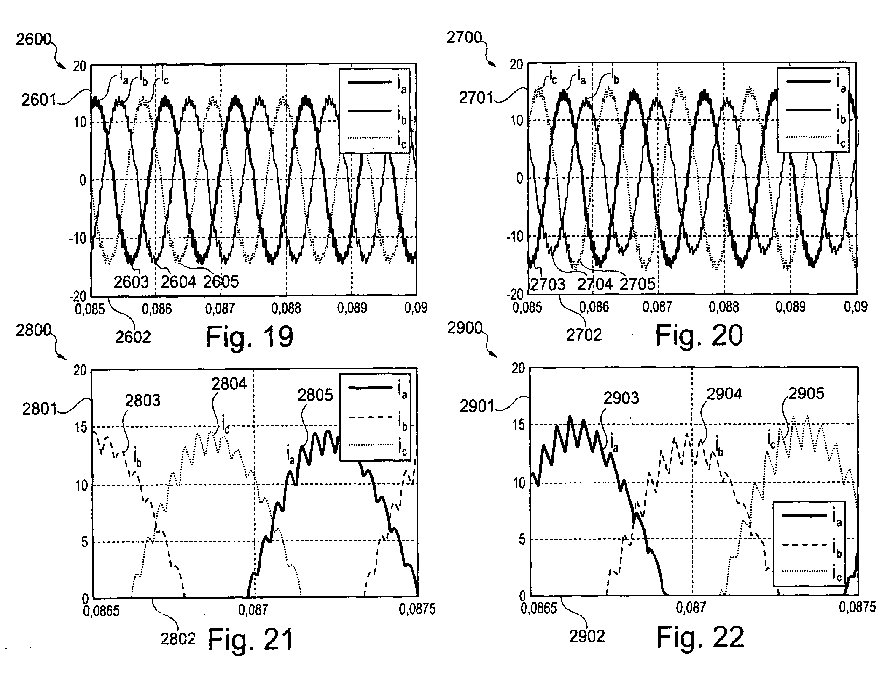

Für die oben beschriebenen Fig. 14, und 22 sowie für die folgenden Fig. 17 und 18, 19, 20, 21 und 22 gelten die folgenden Parameter:

| | |
|---|---|
| Phaseninduktivität: | L1 = 0,0077 |
| Phasenwiderstand: | R1 = 0,06 |
| Windungsverhältnis: | x = 0,2 |
| Kopplungskoeffizient: | k = 0,8 |
| DC Brückenspannung: | Uzk = 270 |
| PWM-Frequenz: | fp = 40.000. |

Fig. 16 zeigt einen Stromkreis für einen Elektromotor mit Drei-Phasen Sternpunkttopologie 2300 mit verschiedenen Spannungsquellen 2308, 2309, 2310, die jeweils über eine Leitung 2301 mit jeweils einer Spule 2302, 2304, 2306 verbunden sind, die eine Induktivität $L_1$, $L_2$, $L_3$ aufweisen und jeweils eine induzierte Spannung $E_1$, 2303, $E_2$, 2305, $E_3$, 2307 aufweisen. Durch jede der Spulen 2302, 2304, 2306 fließt ein entsprechender Strom, $i_1$. $i_2$, $i_3$. Für den Stromkreis gemäß Fig. 16 gelten folgende Formelzusammenhänge:

PWM Arbeitszyklus:

$$\tau_e = \frac{t_e}{T}$$

induzierte Spannung (EMF):

$$E_1 + E_2 = \tau_e \cdot U$$

Strom-Ripple (funktionierend):

$$\Delta i = \frac{U \cdot T}{L_1 + L_2} \cdot \tau_e \cdot (1 - \tau_e)$$

Strom-Ripple (fehlerhaft):

$$\Delta i = \frac{U \cdot T}{L_1 \cdot (1 - k^2) + L_2} \cdot \tau_e \cdot (1 - \tau_e)$$

Bei gleichen Stranginduktivitäten (L1 = L2) vergrößert sich der Strom-Ripple im Fehlerfall nur um den Faktor

$$\frac{2}{2 - k^2}$$

Die Änderung ist damit wesentlich geringer als bei Einzelphasensteuerung.

Fig. 17 zeigt einen PWM-Spannungsverlauf bei einem Arbeitszyklus von 50 % sowie einen Strom-Ripple für einen funktionierenden Stromkreis gemäß Fig. 16 und einen Strom-Ripple für einen Windungsschluss für einen Stromkreis gemäß Fig. 16 über einen bestimmten Zeitverlauf 2400. Die graphische Darstellung 2401 mit einer vertikalen Achse 2402, die eine Spannung von 0 bis 400 Volt anzeigt und einer horizontalen Achse 2403, die einen Zeitverlauf von 0 bis 2 x 10$^{-4}$ Sekunden anzeigt, zeigt den PWM-Spannungsverlauf bei einem Arbeitszyklus von 50 % über die Zeit 2410. Die graphische Darstellung 2404 mit einer vertikalen Achse 2405, die den Stromverlauf von 0 bis 10 Ampere anzeigt, und einer horizontalen Zeitachse 2406 gemäß der Achse 2403, zeigt einen Strom-Ripple bei einem fehlerfrei funktionierenden Stromkreis gemäß Fig. 16 2411. Die graphische Darstellung 2407 zeigt einen mit einer vertikalen Achse 2408, die einen Stromverlauf gemäß der vertikalen Achse 2405 anzeigt, und einer horizontalen Zeitachse 2409 gemäß der Zeitachse 2406, zeigt einen Strom-Ripple bei einem Windungsschluss 2412 für eine Drei-Phasen Sternpunkttopologie.

Fig. 18 zeigt einen PWM-Spannungsverlauf für einen Arbeitszyklus von 25 %, einen Strom-Ripple für einen funktionierenden Stromkreis sowie einen Strom-Ripple bei einem Windungsschluss über die Zeit für einen Stromkreis gemäß Fig. 16 mit Drei-Phasen Sternpunkttopologie 2500. Die graphische Darstellung 2501 mit einer vertikalen Achse 2502, die einen Stromverlauf von 0 bis 400 Volt anzeigt, und einer horizontalen Achse 2503, die einen Zeitverlauf von 0 bis 2 x 10$^{-4}$ Sekunden zeigt, beschreibt den PWM-Spannungsverlauf für einen Arbeitszyklus von 25 % 2510. Die graphische Darstellung 2504 mit einer vertikalen Achse 2505, die den Strom von 0 bis 10 in Ampere anzeigt, und einer horizontalen Zeitachse 2506 gemäß der Zeitachse 2503, zeigt einen Strom-Ripple für einen funktionierenden Stromkreis 2511. Die graphische Darstellung 2507 mit einer Stromachse 2508 gemäß der vertikalen Stromachse 2505 und einer horizontalen Zeitachse 2508 gemäß der Zeitachse 2506 zeigt einen Strom-Ripple für einen Windungsschluss 2512 bei einer Drei-Phasen Sternpunkttopologie.

Die Unterschiede im Strom-Ripple für einen funktionierenden Stromkreis (2411 und 2511) und für einen Windungsschluss (2412 und 2512) sind nur schwer erkennbar.

Bei einer Drei-Phasen Sternpunkttopologie ist daher die Windungsschlussfehlerdetektion ausschließlich durch das Beobachten des Strom-Ripple der Klemmenströme kaum möglich.

Die Fig. 19, 20, 21 und 22 zeigen Phasenströme in DQ-gesteuerten Servoantrieben für 3 x 3 Phasen mit Sternpunkttopologie, wobei nur eine Phasengruppe angezeigt wird.

Fig. 19 zeigt eine graphische Darstellung von Phasenströmen in funktionierenden Phasen 2600. Eine vertikale Achse 2601 bezeichnet den Strom von -20 bis 20 Ampere, eine horizontale Achse bezeichnet die Zeit von 0,085 bis 0,9 Sekunden und die Graphen 2603, $i_a$, 2604, $i_b$, 2605, $i_c$ stellen die Phasenströme der Drei-Phasen mit Sternpunkttopologie dar.

Fig. 20 zeigt eine graphische Darstellung der Phasenströme bei einem Teilkurzschlussfehler in Phase c 2700. Die vertikale Achse 2701 zeigt einen Strom in Ampere gemäß der vertikalen Achse 2601, die horizontale Achse 2702 zeigt die Zeit gemäß der horizontalen Zeitachse 2602 und die Graphen 2703, $i_a$, 2704, $i_b$ und 2705, $i_c$ stellen die Phasenströme für die Drei-Phasen $i_a$, $i_b$ und $i_c$ dar.

Fig. 21 zeigt eine graphische Darstellung der Phasenströme in funktionierenden Phasen in Vergrößerung 2800. Die vertikale Achse 2801 zeigt den Strom von 0 bis 20 Ampere, die horizontale Achse 2802, zeigt den Zeitverlauf von 0,0865 bis 0,0875 Sekunden und die Graphen 2803, 2804, 2805 zeigen die Phasenströmen für die Drei-Phasen $i_a$, $i_b$ und $i_c$.

Fig. 22 zeigt die Phasenströme in vergrößertem Zustand bei einem Fehler in Phase c 2900. Die vertikale Achse 2901 ist identisch mit der vertikalen Achse 2101 ausgeführt und zeigt den Strom in Ampere, die horizontale Achse 2902, ist identisch mit der horizontalen Achse 2802 ausgeführt und zeigt die Zeit. Die Graphen 2903, 2904 und 2905 zeigen den Phasenstrom für die Drei-Phasen $i_a$, $i_b$ und $i_c$ bei einem Fehler in Phase c.

Die in Fig. 19, Fig. 20, Fig. 21 und Fig. 22 dargestellten Phasenströme zeigen, dass der Strom-Ripple sich bei einem Fehler nur leicht erhöht, und die Stromverteilung leicht asymmetrisch wird. Die Detektion des Teilkurzschlusses durch Auswertung der Stromverläufe ist somit bei Sternpunkttopologie nicht praktikabel.

Gemäß dem folgenden Ausführungsbeispiel der Erfindung werden Teilkurzschluss/Windungskurzschlussfehler detektiert, indem das Sternpunktpotential an eine Auswerteeinheit zurückgeführt wird. In der Auswerteeinheit wird dieses Potential mit einem Referenzpotential verglichen und die Potentialdifferenz zwischen Sternpunkt- und Referenzpotential ausgewertet. Das Referenzpotential kann berechnet und mit dem gemessenen Sternpunktpotential verglichen werden oder das Referenzpotential kann über eine geeignete Schaltung analog erzeugt und ebenfalls der Auswerteeinheit zugeführt werden in der dann die Potentialdifferenz zwischen Sternpunkt und Referenzpotential gemessen wird.

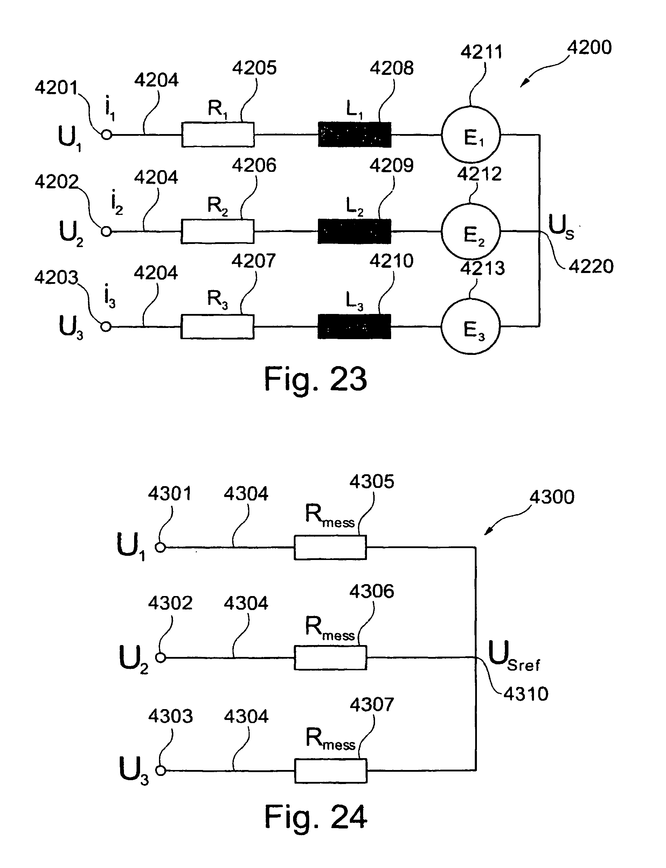

Fig. 23 zeigt eine schematische Darstellung eines Stromkreislaufs mit einer Drei-Phasen Sternpunkttopologie 4200. Spannungsquellen U$_1$, 4201, U2, 4202, U3, 4203 versorgen über Leitungen 4204 entsprechende Spulen mit Widerständen R$_1$, 4205, R$_2$, 4206, R$_3$, 4207 und Induktivitäten L$_1$, 4208, L$_2$, 4209, L$_3$, 4210, wobei entsprechende Ströme $i_1$, $i_2$, $i_3$ durch die entsprechenden Spulen fließen. Jede Spule weist eine entsprechende induzierte Spannung E$_1$, 4211, E$_2$, 4212, E$_3$, 4213 auf und ist über Leitungen 4204 mit einem Sternpunkt 4220 verbunden, an dem das Potential U$_s$ auftritt.

Das Sternpunktpotential eines symmetrischen m-phasigen Systems aus *m* Motorphasen kann für den fehlerfreien Betriebszustand als bekannt vorausgesetzt werden (Rechnung und/oder Messung an Referenzsystem).

$$R_1 = R_2 = R_3 = R$$
$$L_1 = L_2 = L_3 = L$$

Aufgrund der Symmetrie gilt:
$$\sum_{m=1}^{3} E_\mu = 0$$

Am Stromknoten gilt:
$$\sum_{m=1}^{3} i_\mu = 0$$

$$U_S = U_1 + R \cdot i_1 + L \cdot \frac{di_1}{dt} - E_1$$

$$U_S = U_2 + R \cdot i_2 + L \cdot \frac{di_2}{dt} - E_2$$

$$U_S = U_3 + R \cdot i_3 + L \cdot \frac{di_3}{dt} - E_3$$

Die Summe der Spannungen ergibt:

$$3 \cdot U_S = U_1 + U_2 + U_3 + R \cdot \sum i + L \cdot \frac{d}{dt}\left(\sum i\right) - \sum E$$

$$U_S = \frac{U_1 + U_2 + U_3}{3}$$

Das Sternpunktpotential für symmetrische Bedingungen kann bei bekannten Spannungen (z.B. aus dem aktuellen Schaltzustand einer PWM 3-Phasen-Brückenschaltung) direkt berechnet werden, oder durch eine Analogschaltung mit drei gleichen Messwiderständen erzeugt werden (Referenzspannung).

Fig. 24 zeigt eine Schaltung für ein Referenzpotential 4300 mit drei Eingangsspannungen $U_1$, 4301, $U_2$, 4302, $U_3$, 4303, die über Leitungen 4304 mit Messwiderständen $R_{mess}$ 4305, 4306, 4307 verbunden sind. Die Messwiderstände $R_{mess}$ 4305, 4306, 4307 sind über Leitungen 4304 miteinander verbunden, so dass an dem Verbindungspunkt, dem Sternpunkt 4310, eine Referenzspannung $US_{ref}$ gemessen werden kann.

Gemäß eines Ausführungsbeispiels der Erfindung werden als Eingangsspannungen die Klemmenspannungen des Sternpunktsystems verwendet auf das sich das Referenzpotential bezieht. Fehler, und dabei insbesondere auch Windungsschluss-Fehler in einer oder mehreren Motorphasen (f < m) führen zu einer systematischen Abweichung des Sternpunktpotentials vom Potential des Referenzsystems.

Bereits aus den oben angegebenen Gleichungen wird ersichtlich, dass jede Abweichung von den vorausgesetzten Symmetriebedingungen zu einer Potentialdifferenz zwischen $U_s$ und $U_{Sref}$ führen muss.

Bei den in erster Linie betrachteten fehlertoleranten permanenterregten Synchronmotoren für Luftfahrtanwendungen ist der Spannungsabfall am ohmschen Strangwiderstand R sehr klein im Verhältnis zum Spannungsabfall an der Stranginduktivität. Die Stranginduktivität wird absichtlich groß gewählt, da im Fehlerfall (erkannter Windungsschluss) die gesamte Phasengruppe kurzgeschlossen werden soll und der resultierende Kurzschlussstrom dann klein bleiben soll. Es ist deshalb in erster Linie die Unsymmetrie der Induktivitäten, die durch den Potentialvergleich deutlich erkannt wird.

Durch Vergleich des Sternpunktpotentials mit dem Referenzpotential können Fehlerzustände und damit auch insbesondere Windungs-Kurzschlüsse in einer oder mehreren Motorphasen (f < m) der Motorphasengruppe erkannt werden.

Wie bereits an andere Stelle ausgeführt, ändert sich bei einem Windungsschluss die Gesamtinduktivität der betroffenen Phase. Entsprechend reduziert sich der induktive Spannungsabfall $L \cdot \dfrac{di}{dt}$ an der betroffenen Phase und das Sternpunktpotential ändert sich gegenüber dem Referenzpotential. Der Vergleich zwischen dem tatsächlichen Sternpunktpotential und dem Referenzsignal kann nun entweder in analoger Schaltungstechnik oder nach A/D-Wandlung im Steuerrechner durchgeführt werden.

Der Einfluss des Windungsschlusses auf andere messbare Größen, insbesondere auf den Strangstrom, der ja ohnehin gemessen wird, ist sehr gering bzw. schwer detektierbar. Während bei der Einzel-Ansteuerung eines Wicklungsstrangs der Fall des Windungsschlusses bei PWM-Ansteuerung ggf. aus dem "Stromripple" erkennbar ist, wird dieser Effekt bei Anordnungen mit Sternpunkt so verwässert, dass eine Erkennung durch Auswerten der Ströme praktisch nicht möglich ist.

Das Erkennungsverfahren eignet sich sowohl für eine zeitkontinuierliche als auch für eine geschaltete Spannungsversorgung (PWM) der Motorphasengruppe.

Die folgenden Figuren zeigen das Verhalten des Beispielmotors mit zeitkontinuierlich arbeitender Endstufe unter folgenden Randbedingungen:

Drehzahl 100 1/s, Drehmoment = 0,5*Nennmoment,

Windungsschluss in Strang c der Phasengruppe a,b,c

Abweichung der Phaseninduktivität in Phase f um 10%, (Gruppe d,e,f)

Abweichung des Strangwiderstands in Phase i um 10%, (Gruppe g,h,i)

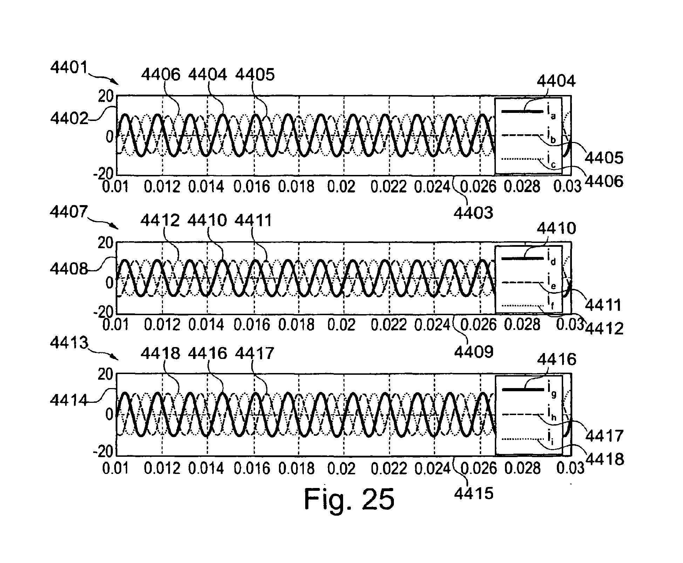

Fig. 25 zeigt Phasenströme a bis i eines Beispielmotors mit zeitkontinuierlicher Spannungsversorgung (keine PWM). Die graphische Darstellung 4401 zeigt Phasenstromverläufe der Phasen a, b, c mit einer vertikalen Achse 4402, die den Strom von -20 bis 20 Ampere anzeigt, und eine horizontale Achse 4403, die den Zeitverlauf von 0,01 bis 0,03 Sekunden anzeigt. Der Graph 4404 zeigt den Stromverlauf der Phase $i_a$ an. Der Graph 4405 zeigt den Stromverlauf der Phase $i_b$ an. Der Graph 4406 zeigt den Stromverlauf der Phase $i_c$ mit Windungsschluss an.

Die graphische Darstellung 4407 mit einer vertikalen Achse 4408 gemäß der vertikalen Achse 4404 und einer horizontalen Achse 4409 gemäß der horizontalen Achse 4403 zeigt den Phasenstromverlauf der Phasen d, e, f an. Der Graph 4410 zeigt den Stromverlauf der Phase $i_d$ an, der Graph 4411 zeigt den Stromverlauf der Phase $i_e$ an und der Graph 4412 zeigt den Stromverlauf der Phase $i_f$ mit Abweichung der Phaseninduktivität an.

Die graphische Darstellung 4413 zeigt den Phasenstromverlauf der Phasen g, h, i an. Die vertikale Achse 4414 entspricht der vertikalen Achse 4402, und die horizontale Achse 4415 entspricht der horizontalen Achse 4403. Der Graph 4416 zeigt den Stromverlauf der Phase ig, der Graph 4417 zeigt den Stromverlauf der Phase $i_h$ und der Graph 4418 zeigt den Stromverlauf der Phase $i_i$ mit Abweichung des Phasenwiderstands an.

Aus Fig. 25 ist keine auswertbare Information in den Stromverläufen erkennbar.

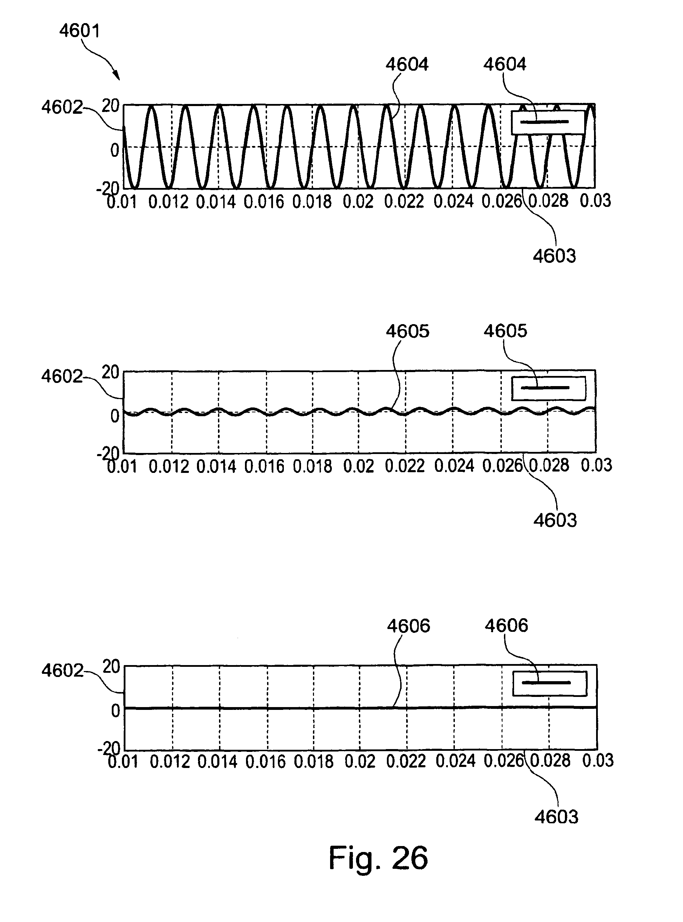

Fig. 26 zeigt die Fehlerspannung eines Beispielmotors mit zeitkontinuierlicher Spannungsversorgung für die Phasen A bis I. Die graphische Darstellung 4601 zeigt die Potentialdifferenz zwischen Sternpunktpotential und Referenzpotential für die Phasen a, b, c, 4601. Die vertikale Achse 4602 zeigt die Potentialdifferenz von -20 bis 20 Volt und die horizontale Achse 4603 zeigt den Zeitverlauf von 0,01 bis 0,03 Sekunden.

Der Graph 4604 zeigt die Sternpunktpotentialdifferenz gegenüber einem Referenzpotential für die Phasen a, b, c, wobei in Phase c ein Windungsschluss vorliegt.

Die graphische Darstellung 4605 zeigt die Potentialdifferenz zwischen Sternpunktpotential und Refernzpotential für die Phasen d, e, f wobei in Phase f die Phaseninduktivität um 10% abweicht.

Die graphische Darstellung 4606 zeigt die Potentialdifferenz zwischen Sternpunktpotential und Refernzpotential im zeitlichen Verlauf für die Phasen g, h, i, wobei in Phase i der Phasenwiderstand um 10% abweicht.

Gemäß zweier Ausführungsbeispiele der Erfindung können bei geschalteter Speisung durch einen PWM-Verstärker zur Fehlererkennung wahlweise sowohl die Augenblickswerte der Potentialdifferenz als auch die über ein Filter geglätteten Messwerte (gleitende Mittelwerte) der Potentialdifferenzen herangezogen werden. Normalerweise werden die Phasen über PWM-Endstufen (eine Halbbrücke pro Phase) versorgt. In diesem Fall ändert sich das Sternpunktpotential mit jeder Schaltflanke. Vernachlässigt man den Spannungsabfall am Schalter ergeben sich zwischen den Schaltflanken für das Referenz-Sternpunktpotential nur 4 diskrete Zustände, abhängig von der Zwischenkreisspannung UZK:

| | |
|---|---|
| 3 Halbbrücken auf Low-Potential: | $U_{Sref} = 0$ |
| 2 Halbbrücke auf Low-Potential: | $U_{Sref} = UZK/3$ |
| 1 Halbbrücken auf Low-Potential: | $U_{Sref} = 2*UZK/3$ |
| 3 Halbbrücken auf UZK-Potential: | $U_{Sref} = UZK$ |

Das tatsächlich messbare Sternpunktpotential weicht im Fehlerfall von diesen Werten ab.

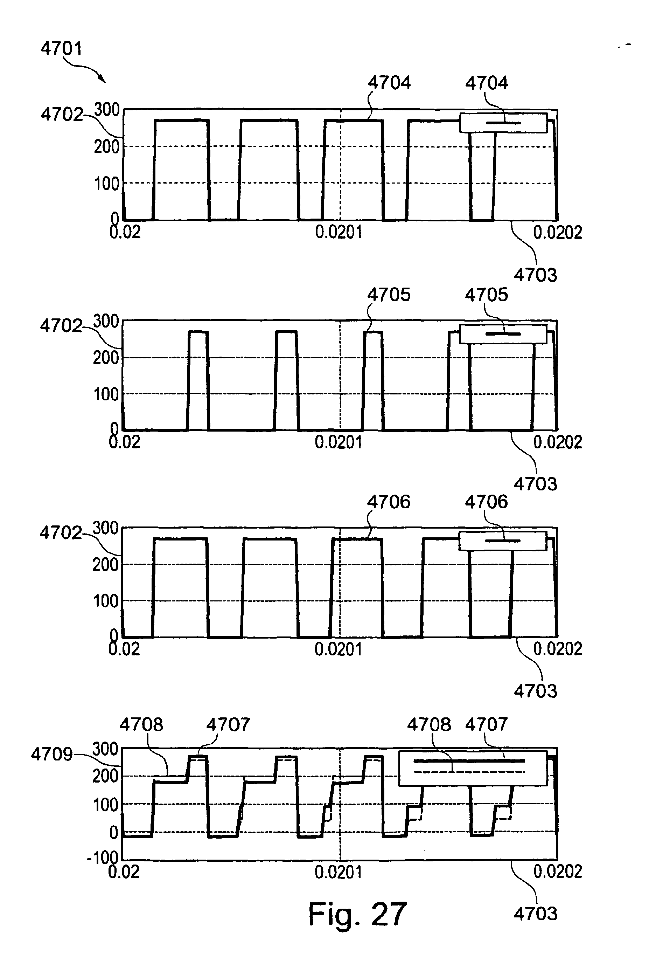

Fig. 27 zeigt vier graphische Darstellungen für Ansteuerspannungen und Sternreferenz-Sternpunktpotentiale 4701, die sich zwischen den Schaltflanken in Abhängigkeit von der Zwischenkreisspannung UZK ergeben, wobei die vertikalen Achsen 4702, die Spannung von 0 bis 300 Volt anzeigen, die vertikale Achse 4709 die Spannung von -100 bis 300 Volt anzeigt und die horizontalen Achsen 4703 den zeitlichen Verlauf von 0,02 bis 0,0202 Sekunden anzeigen.

Der Graph 4704 zeigt den PWM-Spannungsverlauf für die Klemme der PWM-Phase a.

Der Graph 4705 zeigt den PWM-Spannungsverlauf für die Klemme der PWM-Phase b.

Der Graph 4706 zeigt den PWM-Spannungsverlauf für die Klemme der PWM-Phase c.

Der Graph 4707 zeigt einen idealen Sternpunktpotentialverlauf, während der Graph 4708 den bei einem Teilkurzschluss in Phase c gemessenen

Sternpunktpotentialverlauf anzeigt. Die graphische Darstellung der Graphen 4707 und 4708 weisen eine vertikale Achse 4709 auf, die die Spannung von -100 bis 300 Volt anzeigt.

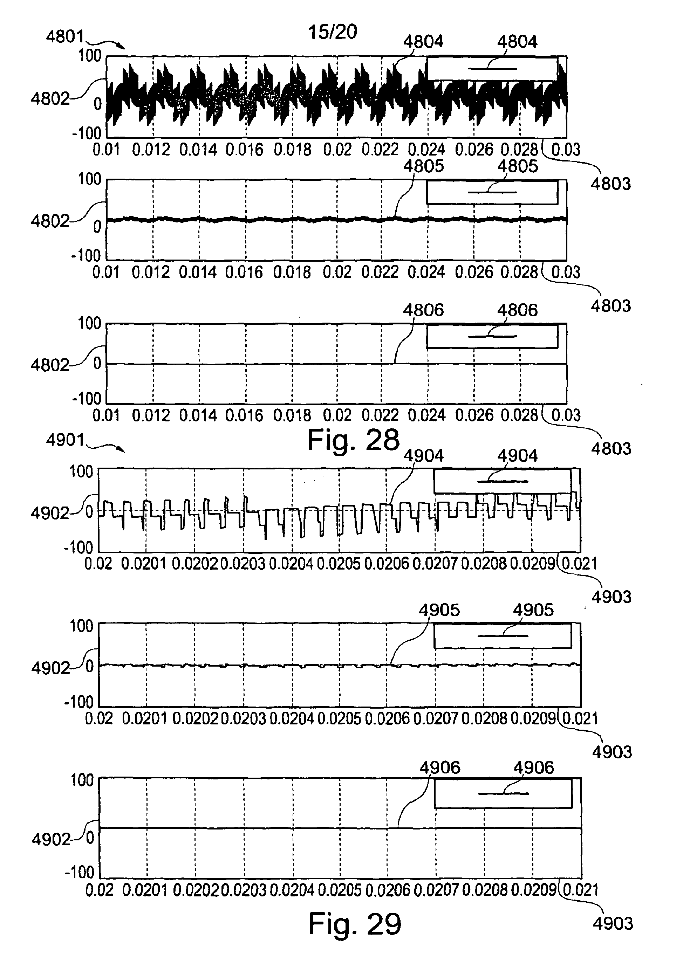

Der Zeitverlauf der ungefilterten Fehlersignale (Differenz zwischen idealem und gemessenem Stempunktpotential) für einen etwas größeren Zeitraum ist in den Fig. 28 und 29 in unterschiedlichen Zoom-Darstellungen gezeigt.

Fig. 28 zeigt die ungefilterte Sternpunktpotentialdifferenz für die Phasen a, b, c, die Phasen d, e, f und die Phasen g, h, i, wobei die vertikalen Achsen 4802 die Potentialdifferenz von -100 bis 100 Volt darstellen, und die horizontalen Achsen 4803 den zeitlichen Verlauf von 0,01 bis 0,03 Sekunden zeigen. Der Graph 4804 zeigt den Sternpunktpotentialdifferenzverlauf für die Phasen a, b, c mit Windungsschluss in Phase c. Der Graph 4805 zeigt den Sternpunktpotentialdifferenzverlauf für die Phasen d, e, f mit Induktivitätsabweichung (10%) in Phase f. Der Graph 4806 zeigt den Sternpunktpotentialdifferenzverlauf für die Phasen g, h, i mit Widerstandsabweichung (10%) in Phase i.

Fig. 29 zeigt den ungefilterten Sternpunktpotentialdifferenzverlauf 4901, für die Phasen a, b, c, die Phasen d, e, f und die Phasen g, h, i. Die vertikalen Achsen 4902 zeigen die Potentialdifferenz von -100 bis 100 Volt und die horizontalen Achsen 4903 zeigen den zeitlichen Verlauf von 0,02 bis 0,021 Sekunden. Der Graph 4904 zeigt den ungefilterten Sternpunktpotentialdifferenzverlauf für die Phasen a, b, c. Der Graph 4905 zeigt den ungefilterten Sternpunktpotentialdifferenzverlauf für die Phasen d, e, f. Der Graph 4906 zeigt den ungefilterten Sternpunktpotentialdifferenzverlauf für die Phasen g, h, i.

Die Breite der impulsförmigen Fehlerspannungen hängt vom Abstand der Schaltflanken ab und wird bei kleinen Spannungs-Grundwellenamplituden (d.h. bei kleinen Drehzahlen) sehr schmal. Dies ist zumindest dann der Fall, wenn die PWM-Ansteuerung der 3 Halbbrücken eines Sternpunktsystems synchronisiert und ohne Phasenverschiebung erfolgt, d.h. dass z.B. die fallende Flanke eines jeden PWM-Zyklus auf allen 3 Halbbrücken zeitgleich auftritt (vgl. Fig. 27). Bei kleinen Spannungsamplituden weicht das PWM Verhältnis aller Halbbrücken nur wenig von 50% ab und damit "kommen" auch die steigenden Flanken fast zeitgleich.

Gemäß einem Ausführungsbeispiel der Erfindung lässt sich durch geeignete Modifikation der Ansteuerung der Halbbrücken die Breite der impulsförmigen Fehlerspannungen auch bei kleinen Spannungsamplituden (PWM-Verhältnis etwa 50% auf allen Halbbrücken) vergrößern, beispielsweise durch:

- Einstellung einer Phasenverschiebung von z.B. jeweils 120° zwischen der synchronisierten PWM der drei Halbbrücken
- nicht synchronisierte PWM, d.h. Schwebung der Schaltzeitpunkte der einzelnen Halbbrücken gegeneinander.

Damit ist es zwar theoretisch möglich die Spannungsdifferenzen zwischen den Schaltflanken zu detektieren, praktisch aber aufwändig zu realisieren. Eine weitere Schwierigkeit stellen durch die Schaltflanken ausgelöste Schwingungen parasitärer Schwingkreise dar (z.B. erzeugt durch ein parasitäres C gegen Masse am Sternpunkt), die in den kurzen zur Messung zur Verfügung stehenden Zeitfenstern möglicherweise kaum abklingen. Je nach deren Resonanzfrequenz und Dämpfung lässt sich die gemessene Sternpunktspannung auch nur schwer filtern.

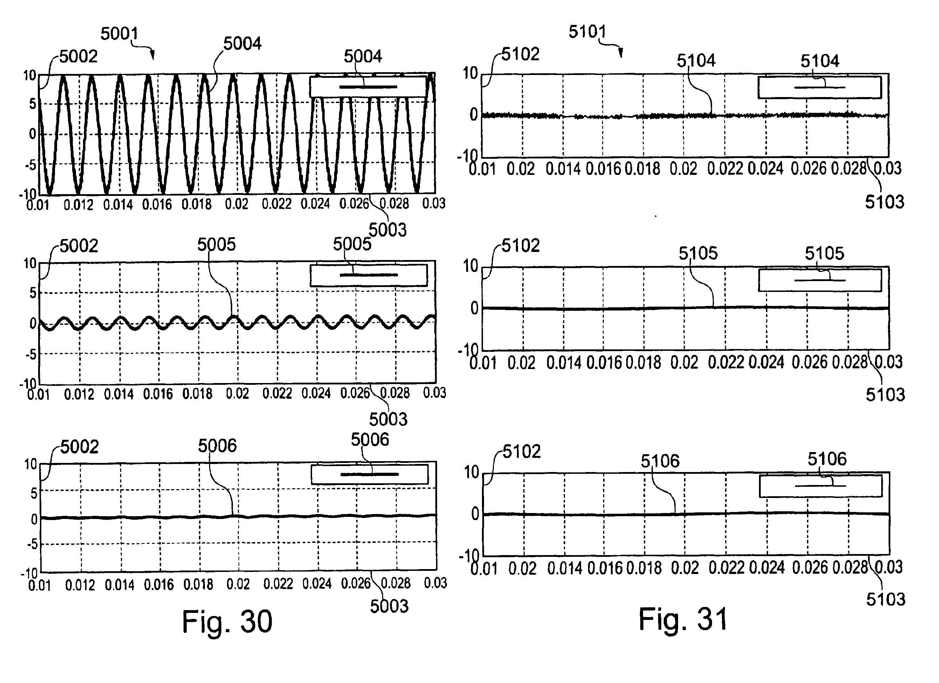

Glättet man dagegen den Verlauf des Fehlersignals durch ein Tiefpassfilter, ergibt sich ein quasikontinuierliches Fehlersignal, dessen Amplitude leicht auszuwerten ist (Fig. 30).

Fig. 30 zeigt ein gefiltertes Fehlersignal 5001, wobei in drei graphischen Darstellungen Sternpunktdifferenzpotential gefilterte Sternpunktpotentialdifferenzverläufe für die Phasen a, b, c, die Phasen d, e, f und die Phasen g, h, i gezeigt werden. Die vertikalen Achsen 5002 zeigen die Potentialdifferenz von -10 bis +10 Volt und die horizontalen Achsen 5003 zeigen den zeitlichen Verlauf von 0,01 bis 0,03 Sekunden. Der Graph 5004 zeigt den Sternpunktpotentialdifferenzverlauf im gefilterten Zustand für die Phasen a, b, c, wobei in Phase c ein Windungsschluss vorliegt. Der Graph 5005 zeigt den gefilterten Sternpunktpotentialdifferenzverlauf der Phasen d, e, f, wobei in Phase f die Wicklungsinduktivität um 10% abweicht. Der Graph 5006 zeigt den Sternpunktpotentialdifferenzverlauf im gefilterten Zustand für die Phasen g, h, i, wobei in Phase i der Wicklungswiderstand um 10% abweicht.

Es ist anzumerken, dass der Verlauf des geglätteten Fehlersignals, abgesehen von einem kleinen Ripple, exakt dem Fehlersignal entspricht, das mit einer zeitkontinuierlich arbeitenden Endstufe entstünde (Fig. 26).

Eine Erweiterung des Verfahrens erlaubt die Fehlererkennung auch bei fehlender oder zu geringer "natürlicher" Anregung des Mehrphasensystems. Im Stillstand oder bei geringer Motordrehzahl sind die Grundwellenamplituden der Strangspannungen zu gering, um ein praktisch auswertbares Fehlersignal zu erzeugen.
Für diesen Fall kann die Phasengruppe gezielt durch die Einprägung von Blindströmen angeregt werden. Dies ermöglicht eine sichere Fehlererkennung ohne störende Drehmomentpulsationen zu erzeugen.

Es kann gezeigt werden, dass die Amplitude des Fehlersignals nicht von der Drehmoment- bzw. Strombelastung, aber von der Frequenz (Drehzahl) und Spannung des Motors abhängt. Bei geringer Drehzahl und entsprechend geringer (mittlerer) Motorspannung wird daher das Fehlersignal ohne weitere Maßnahme so klein, dass es praktisch nicht mehr verwertbar ist.

Fig. 31 zeigt den gefilterten Sternpunktpotentialdifferenzverlauf bei geringer Drehzahl und entsprechend geringer Motorspannung für ein Fehlersignal für die Phasen a, b, c, die Phasen d, e, f und die Phasen g, h, i. Die vertikalen Achsen 5102 zeigen die Potentialdifferenz von -10 bis +10 Volt und die horizontalen Achsen 5103 zeigen den zeitlichen Verlauf von 0,01 bis 0,03 Sekunden. Der Graph 5104 zeigt den Sternpunktpotentialdifferenzverlauf für die Phasen a, b, c mit Windungsschluss in Phase c. Der Graph 5105 zeigt den Sternpunktpotentialdifferenzverlauf für die Phasen d, e, f mit Induktivitätsabweichung in Phase f. Der Graph 5106 zeigt den Sternpunktpotentialdifferenzverlauf für die Phasen g, h, i mit Widerstandsabweichung in Phase i.

Fig. 31 zeigt die Fehlerspannungen bei einer von 100 l/s auf 10 l/s reduzierten Drehzahl. Eine praktisch sinnvolle Auswertung ist hier nicht mehr möglich, bei noch kleineren Drehzahlen erst recht nicht.

Gemäß einem Ausführungsbeispiel der Erfindung wird deshalb gezielte ein relativ hochfrequenter Blindstroms in die Statorwicklung eingeprägt. Dies bedingt wegen der hohen Wicklungsinduktivität auch nennenswerte Spannungsamplituden an den Klemmen. Der Blindstrom trägt nicht zur Drehmomentbildung bei und ist somit an der Motorwelle nicht spürbar.

Gemäß einem Ausführungsbeispiel der Erfindung ist eine praktische Möglichkeit, diesen Blindstrom zu erzeugen, die Nutzung der (meist ohnehin vorhandenen) Stromregelung in d/q-Koordinaten. Bei diesem bekannten Verfahren wird mit Hilfe von Koordinatentransformationen der drehmomentbildende Wirkstrom Iq und der feldbildende Blindstrom Id getrennt geregelt. Entsprechend gibt es auch getrennte Soll- und Istwerte für den Wirkstrom Iq und den Blindstrom Id.

Gemäß einem Ausführungsbeispiel der Erfindung wird die gewünschte Anregung erzeugt, indem bei kleinen Drehzahlen dem Id-Regler statt Sollwert Null ein (z.B. sinusförmig) moduliertes Sollsignal vorgegeben wird.

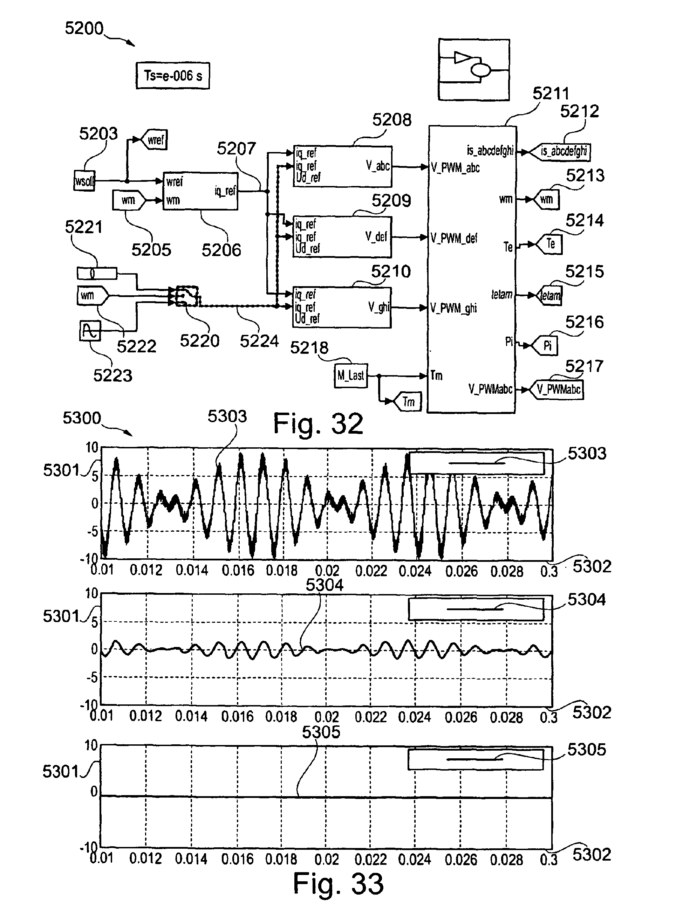

Fig. 32 zeigt eine schematische Darstellung eines Ansteuerverfahrens zur Fehlerdetektion bei geringer Motordrehzahl für einen PMSM mit Sternpunkttopologie 5200. Eine Geschwindigkeitsregelung 5206 wertet eine Motor-Sollgeschwindigkeit wsoll 5203 gegenüber einer Motor-Istgeschwindigkeit wm 5205 aus. Die Geschwindigkeitsregelung 5206 ist über Leitungen 5207 mit Stromregeleinheiten 5208, 5209, 5210 verbunden und speist in diese Einheiten einen Referenzstrom iq_ref ein. Die Stromregeleinheiten 5208, 5209, 5210 sind über Leitungen mit einer Leistungsstufe und einem PMSM 5211 verbunden und versorgen diesen mit jeweiligen Phasenspannungen v_abc, v_def, v_ghi. An der PMSM 5211 ist eine Last 5218 angeschlossen. Ferner sind an der Leistungsstufe und am PMSM 5211 mehrere Messstellen 5212 bis 5217 angeschlossen, insbesondere Messstellen für die Phasenströme 5212, die Winkelposition der Motorwelle 5215 und die Motorlstgeschwindigkeit 5213. Ein Schalter 5220 führt entweder das Signal 0 5212 oder sinusförmig Anregungen 5223 an die Stromregeleinheiten 5208, 5209, 5210. Die Umschaltung kann zum Beispiel in Abhängigkeit von der Motordrehzahl 5222 vorgenommen werden. Das von dem Schalter 5220 an die Stromregeleinheiten 5208, 5209, 5210 ausgegebene Signal wird als moduliertes Sollsignal 5224 bezeichnet.

Als Ergebnis der Anordnung gemäß Fig. 32 erhält man ein Fehlersignal dessen Maximalamplitude und Frequenz sich aus der zur Erzeugung des Blindstroms erforderlichen Spannung ergibt, wie in Fig. 33 gezeigt wird.

Fig. 33 zeigt einen dem Aufbau nach der Fig. 32 entsprechenden gefilterten Stempunktpotentialdifferenzverlauf für die Phasen a, b, c, die Phasen d, e, f und die Phasen g, h, i eines PMSMs 5300. Die vertikalen Achsen 5301 bezeichnen die Potentialdifferenzen von -10 bis 10 Volt und die horizontalen Achsen 5302 bezeichnen den zeitlichen Verlauf von 0,01 bis 0,03 Sekunden. Der Graph 5303 zeigt den gefilterten Sternpunktpotentialdifferenzverlauf für die Phasen a, b, c, wobei in Phase c ein Windungsschluss vorliegt. Der Graph 5304 zeigt den gefilterten Sternpunktpotentialdifferenzverlauf für die Phasen d, e, f, wobei in Phase f die Wicklungsinduktivität um 10% abweicht. Der Graph 530 zeigt den gefilterten Sternpunktpotentialdifferenzverlauf für die Phasen g, h, i, wobei in Phase i der Wicklungswiderstand um 10% abweicht.

Zusätzlich zur Frequenz der Blindstromanregung (wie für Fig. 32 beschrieben) sind diese Fehlersignale mit der aus der Drehzahl resultierenden Motorfrequenz bzw. in Abhängigkeit von der Rotorstellung amplitudenmoduliert. Dass eine Auswertung und damit Fehlererkennung möglich ist, kann der Figur 50 entnommen werden. Nachteilig ist der zusätzliche Blindleistungsbedarf, der aber durchaus in einem vertretbaren Rahmen liegt. Auch die erforderlichen Blindstromamplituden liegen in einem vertretbaren Rahmen.

Gemäß einem Ausführungsbeispiel der Erfindung kann der Nachteil dadurch minimiert werden, dass die Aufschaltung nicht kontinuierlich, sondern nur in diskreten, kurzen Zeitabschnitten als "Burst" aktiviert wird. Damit können die zusätzlichen Motorverluste auf ein Minimum reduziert werden. In den folgenden Figuren ist die Auswirkung der Maßnahme auf die Phasenströme dargestellt.

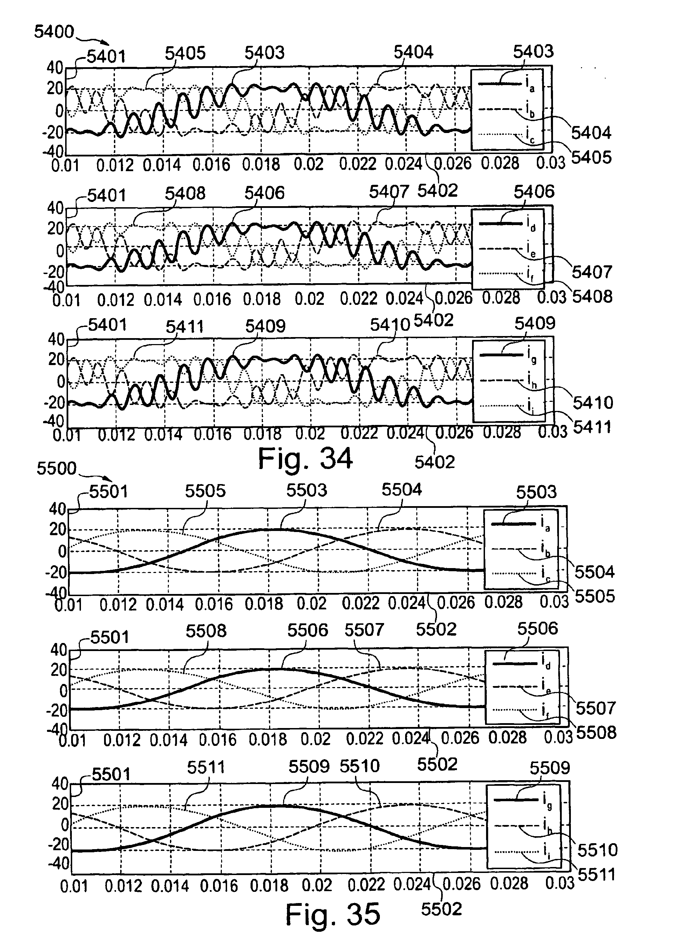

Fig. 34 zeigt Phasenströme mit überlagerten höherfrequenten Blindstromanteilen 5400 für die Phasen a, b, c, für die Phasen d, e, f und die Phasen g, h, i des oben beschriebenen PMSMs. Die vertikalen Achsen 5401 zeigen den Stromverlauf von -40 bis +40 Ampere und die horizontalen Achsen 5402 zeigen den zeitlichen Verlauf von 0,01 bis 0,03 Sekunden.

Der Graph 5403 zeigt den Phasenstromverlauf der Phase $i_a$, der Graph 5404 zeigt den Phasenstromverlauf der Phase $i_b$ und der Graph 5405 zeigt den Phasenstromverlauf der Phase $i_c$.

Der Graph 5406 zeigt den Phasenstromverlauf der Phase $i_d$, der Graph 5407 zeigt den Phasenstromverlauf der Phase $i_e$ und der Graph 5408 zeigt den Phasenstromverlauf der Phase $i_f$.

Der Graph 5409 zeigt den Phasenstromverlauf der Phase ig, der Graph 5410 zeigt den Phasenstromverlauf der Phase $i_h$ und der Graph 5411 zeigt den Phasenstromverlauf der Phase $i_i$.

Fig. 35 zeigt die Wirkströme ohne überlagerten Blindstromanteil 5500 für die Phasenströme a, b, c, die Phasenströme d, e, f und die Phasenströme g, h, i des oben beschriebenen PMSM. Die vertikalen Achsen 5501 zeigen den Stromverlauf von -40 bis +40 Ampere und die horizontalen Achsen 5502 zeigen den zeitlichen Verlauf von 0,01 bis 0,03 Sekunden. Der Graph 5503 zeigt den Phasenstromverlauf für die Phase $i_a$, der Graph 5504 zeigt den Phasenstromverlauf für die Phase $i_b$ und der Graph 5505 zeigt den Phasenstromverlauf für die Phase $i_c$. Der Graph 5506 zeigt den Phasenstromverlauf der Phase $i_d$, der Graph 5507 zeigt den Phasenstromverlauf der Phase $i_e$ und der Graph 5508 zeigt den Phasenstromverlauf der Phase $i_f$. Der Graph 5509 zeigt den Phasenstromverlauf der Phase $i_g$, der Graph 5510 zeigt den Phasenstromverlauf der Phase $i_h$ und der Graph 5511 zeigt den Phasenstromverlauf der Phase $i_i$.

Es wird noch einmal betont, dass die Überlagerung der Blindströme keinen Einfluss auf das durch die Phasengruppen erzeugte Drehmoment hat.

Gemäß einem weiteren Ausführungsbeispiel der Erfindung kann die Messung des Sternpunktpotentials erfolgen, ohne dass eine Messleitung zum Sternpunkt vorhanden ist.

Schaltet man beide Transistoren einer Halbbrücke des Sternpunktsystems hochohmig (z.B. die Transistoren an Klemme 1 in Fig. 23), baut sich der Strom in diesem Zweig des Sternpunktsystems schnell ab. Man kann dann durch eine Spannungsmessung an der Klemme 1 auf das Sternpunktpotential schließen. Dieses Verfahren kann nacheinander an allen 3 Klemmen des Sternpunktsystems durchgeführt werden. Man erhält so unter Nutzung der Steuerleitungen Zugang zur Sternpunktspannung ohne dieses Potential mit einer gesonderten Messleitung in die Elektronikeinheit rückführen zu müssen. Die Spannungsmessung an einer Klemme eines Sternpunktsystems, in deren zugeordneter Halbbrücke beide Transistoren gleichzeitig hochohmig geschaltet sind, verwendet man auch bei gängigen Verfahren zur sensorlosen Kommutierung von BLDC-Motoren. Idealerweise fügt man eine solche Phase im Bereich des regulären Strom-Nulldurchgangs im betreffenden Sternpunktzweig ein. Ein ggf. fließender "Reststrom" baut sich dann besonders schnell ab. Die gemessene Spannung lässt sich für i1=0 und di1/dt=0 aus den Spannungsgleichungen

$$U_S = U_1 + R \cdot i_1 + L \cdot \frac{di_1}{dt} - E_1 ;$$

$$U_S = U_2 + R \cdot i_2 + L \cdot \frac{di_2}{dt} - E_2 ; \quad U_S = U_3 + R \cdot i_3 + L \cdot \frac{di_3}{dt} - E_3$$

ableiten:

$$U1 = Us + E1 \qquad \text{(beispielhaft für Klemme 1)}$$

Ist das Sternpunktsystem Teil eines elektronisch kommutierten Synchronmotors, der nicht in der Feldschwächung betrieben wird, so erfolgen der Nulldurchgang des Stromes i und der induzierten Spannung E in einem beliebigen Zweig des Sternpunktsystems gleichzeitig. Die Spannung $E_1$ ist also im Zeitbereich des Stromnulldurchganges von $i_1$ sehr klein und das gemessene Potential $U_1$ entspricht fast dem Sternpunktpotential $U_S$. Jeweils um 120° elektrisch phasenverschoben ist analog an den Klemmen $U_2$ und $U_3$ das Sternpunktpotential einer Messung zugänglich.
Gemäß einem weiteren Ausführungsbeispiel der Erfindung lässt sich das beschriebene Verfahren auch für Feldschwächbetrieb (wo die Nulldurchgänge von Strom und induzierter Spannung nicht mehr in Phase sind) anwenden, indem z.B. im Steuerrechner der Motorelektronik ein Beobachter-Algorithmus für den Motor in Echtzeit mitgerechnet wird. Die Spannungsmessung an z.B. der Klemme $U_1$ erfolgt weiterhin im Bereich des Strom-Nulldurchganges von $i_1$ mit zwei hochohmig geschalteten Transistoren in der zugehörigen Halbbrücke. Als momentane induzierte Spannung $E_1$ in Zweig 1 des Sternpunktsystems wird der entsprechende Wert aus dem Beobachteralgorithmus eingesetzt. Das Sternpunktpotential berechnet sich zu

$$U_S = U_1 - E_1 \qquad \text{(beispielhaft für Klemme 1)}.$$

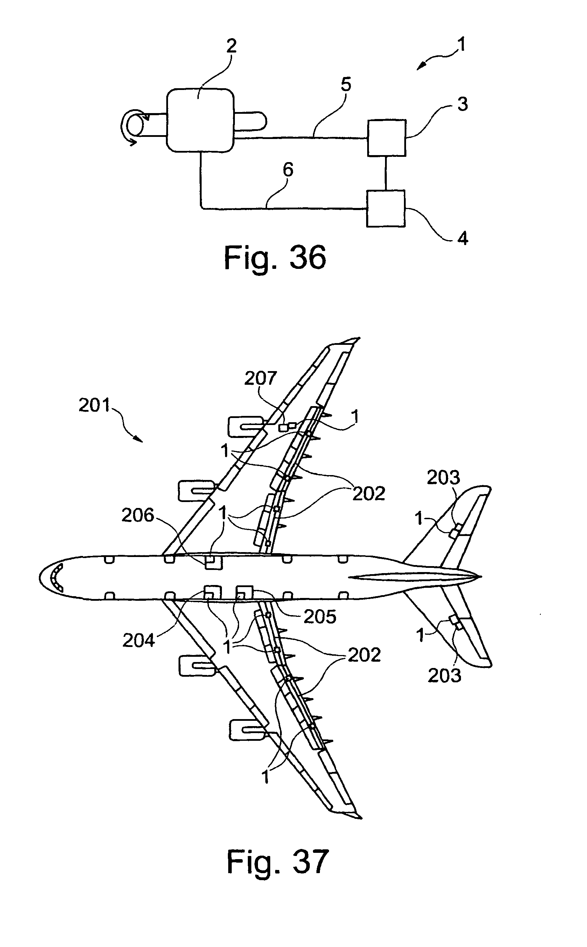

Fig. 36 zeigt eine schematische Darstellung einer Detektions- und Steuervorrichtung 1 mit einem Elektromotor 2 mit Sternpunkttopologie zur Detektion eines Motorfehlers des Elektromotors 2. Der Elektromotor 2 der Detektions- und Steuervorrichtung 1 ist über eine Rückführungseinheit 5 mit einer Auswertungseinheit 3 verbunden und über Steuerleitungen 6 mit der Steuereinheit 4 verbunden. Über die Rückführungseinheit 5 wird ein Sternpunktpotenzial des Elektromotors 2 an die Auswertungseinheit 3 rückgeführt. Die Auswertungseinheit 3 wertet das Sternpunktpotenzial aus. Die Steuereinheit 4 ist mit der Auswertungseinheit 3 verbunden und dient der Passivierung eines Motorfehlers auf Basis der Auswertung der Auswertungseinheit 3. Mit der im vorangehenden Abschnitt beschriebenen Erweiterung des Verfahrens kann die Rückführungseinheit 5 entfallen und Steuereinheit 4 und Auswertungseinheit 3 können zusammengefasst werden.
Fig. 37 zeigt eine schematische Aufsicht eines Luftfahrzeugs 201 mit mehreren Detektions- und Steuervorrichtungen 1. An den Flügeln des Luftfahrzeugs sind mehrere Landeklappenantriebssysteme 202 mit mehreren Detektions- und Steuervorrichtungen 1 angebracht. Im Heckbereich des Luftfahrzeugs sind im Bereich des Höhenruders des Luftfahrzeugs Stellantriebe 203 mit Detektions- und Steuervorrichtungen 1 angeordnet. Im Rumpfbereich des Luftfahrzeugs sind jeweils ein Kompressormotor 204 (beispielsweise für eine Turbine oder ein Kabinen-Klimasystem), ein Pumpenmotor 205 (beispielsweise für Treibstoff, Kühlmittel und/oder Hydraulik) sowie ein elektrischer Generator 206 mit jeweils einer Detektions- und Steuervorrichtung 1 angeordnet. An einem Flügel des Luftfahrzeugs 201 ist ein Fan- oder Propellerantrieb 207 mit einer Detektions- und Steuervorrichtung 1 angeordnet. Stellantrieb(e) 203, Kompressormotor 204, Pumpenmotor 205, elektrischer Generator 206 sowie Fan- und Propellerantrieb 207 sind auch in anderen Bereichen des Luftfahrzeugs 201 anordenbar und sind auch einzeln für sich oder in einem anderen Transportmittel mit einer Detektions- und Steuervorrichtung 1 ausführbar.

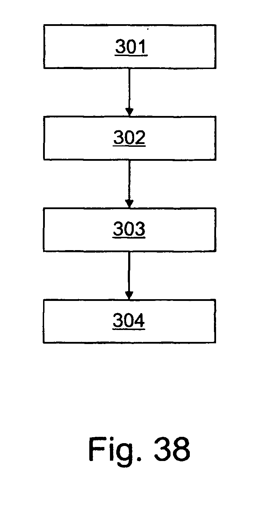

Fig. 38 zeigt ein Flussdiagramm eines Verfahrens zur Detektion eines Motorfehlers eines Elektromotors 2 mit Sternpunkttopologie. In einem ersten Schritt erfolgt ein Bereitstellen einer Auswertungseinheit 3, einer Steuereinheit 4 und einer Rückführungseinheit 5, 301. Der zweite Schritt besteht aus der Rückführung eines Sternpunktpotenzials des Elektromotors 2 über die Rückführungseinheit 5 an die Auswertungseinheit 3 oder über die Steuerleitungen 6 an die Steuereinheit 4, 302. In einem dritten Schritt erfolgt die Auswertung des Sternpunktpotenzials durch die Auswertungseinheit 3 oder durch die Steuereinheit 4, 303. Der letzte Schritt umfasst die Passivierung des Motorfehlers durch die Steuereinheit 4 auf Basis der Auswertung 304.
Obwohl die Erfindung unter Bezugnahme auf Ausführungsbeispiele beschrieben wurde, können verschiedene Änderungen und Modifikationen vorgenommen werden, ohne den Schutzbereich der Erfindung zu verlassen. Die Erfindung kann auch in anderen Bereichen als der Luftfahrt, beispielsweise in Zügen, Bussen oder Schiffen oder jeglichen Transportmitteln verwendet werden, wo ebenfalls eine Detektions- und Steuervorrichtung zur Detektion eines Motorfehlers eines Elektromotors mit Sternpunkttopologie benötigt wird oder gewünscht ist.
Ergänzend ist darauf hinzuweisen, dass "umfassend" keine anderen Elemente oder Schritte ausschließt und "eine" oder "ein" keine Vielzahl ausschließt. Ferner sei darauf hingewiesen, dass Merkmale oder Schritte, die mit Verweis auf eines der obigen Ausführungsbeispiele beschrieben worden sind, auch in Kombination mit anderen Merkmalen oder Schritten anderer oben beschriebener Ausführungsbeispiele verwendet werden können. Bezugszeichen in den Ansprüchen sind nicht als Einschränkung anzusehen.

**Patentansprüche**

1. Detektions- und Steuervorrichtung (1) zur Detektion eines Motorfehlers eines Elektromotors (2) mit Sternpunkttopologie, die Detektions- und Steuervorrichtung (1) aufweisend:

    eine Auswertungseinheit (3);
    eine Steuereinheit (4);
    eine Rückführungseinheit (5);
    mehrere Steuerleitungen (6);
    wobei die Rückführungseinheit (5) zur Rückführung eines Sternpunktpotentials des Elektromotors (2) an die Auswertungseinheit (3) ausgeführt ist;
    wobei die Auswertungseinheit (3) zur Auswertung des Stempunktpotentials ausgeführt ist;
    wobei die Steuereinheit (4) zur Passivierung eines Motorfehlers auf Basis der Auswertung ausgeführt ist; **dadurch gekennzeichnet, dass**
    die Auswertung auf Basis eines Vergleichs des Stempunktpotentials mit einem Referenzpotential erfolgt;
    wobei eine auswertbare Fehlerspannung zwischen Stempunkt- und Referenzpotential durch die Steuereinheit (4) durch das gezielte Einprägen eines Blindstromanteils über die Steuerleitungen (6) in die Statorwicklung des Motors (2) erzeugt wird.

2. Detektions- und Steuervorrichtung (1) nach Anspruch 1, wobei die Auswertung auf Basis eines Vergleichs des Stempunktpotentials mit einem Referenzpotential erfolgt,
   wobei das Referenzpotential berechnet ist.

3. Detektions- und Steuervorrichtung (1) nach Anspruch 1, wobei die Auswertung auf Basis eines Vergleichs des Sternpunktpotentials mit einem Referenzpotential erfolgt,
   wobei das Referenzpotential analog erzeugt ist.

4. Detektions- und Steuervorrichtung (1) nach einem der vorhergehenden Ansprüche, wobei die Passivierung durch Kurzschließen eines Sternpunktsystems, in dem ein Motorfehler detektiert wurde, erfolgt.

5. Detektions- und Steuervorrichtung (1) nach einem der vorhergehenden Ansprüche, wobei die Passivierung die Begrenzung eines Kurzschlussstromes und eines daraus resultierenden Störmomentes bei einem Elektromotor (2) ermöglicht.

6. Detektions- und Steuervorrichtung (1) nach einem der vorhergehenden Ansprüche, wobei die Rückführungseinheit (5) als Verbindungsleitung zwischen einem Sternpunkt des Elektromotors (2) und der Auswertungseinheit (3) ausgeführt ist.

7. Detektions- und Steuervorrichtung (1) nach einem der Ansprüche 1 bis 5, wobei die Rückführung des Stempunktpotentials des Elektromotors (2) an die Steuereinheit (4) durch die Steuerleitungen (6) erfolgt, so dass die Steuerleitungen (6) die Funktion der Rückführungseinheit (5) und die Steuereinheit (4) die Funktion der Auswertungseinheit (3) mit übernehmen.

8. Detektions- und Steuervorrichtung (1) nach einem der vorhergehenden Ansprüche, wobei die Auswertungseinheit (3) und die Steuereinheit (4) integriert miteinander ausgeführt sind.

9. Elektromotor (2) mit einer Detektions- und Steuervorrichtung (1) nach einem der Ansprüche 1 bis 8.

10. Luftfahrzeug (201) mit einer Detektions- und Steuervorrichtung (1) nach einem der Ansprüche 1 bis 8.

11. Landeklappenantriebssystem (202) mit einer Detektions- und Steuervorrichtung (1) nach einem der Ansprüche 1 bis 8.

12. Verwendung einer Detektions- und Steuervorrichtung (1) nach einem der Ansprüche 1 bis 8 in einem Luftfahrzeug (201).

**13.** Verfahren zur Detektion eines Motorfehlers eines Elektromotors (2) mit Sternpunkttopologie, das Verfahren aufweisend die Schritte:

Bereitstellen einer Auswertungseinheit (3), einer Steuereinheit (4), einer Rückführungseinheit (5) und mehrerer Steuerleitungen (6, 301);

Rückführung eines Stempunktpotentials des Elektromotors (2) über die Rückführungseinheit (5) an die Auswertungseinheit (3, 302);

Auswertung des Stempunktpotentials durch die Auswertungseinheit (3, 303);

Passivierung des Motorfehlers durch die Steuereinheit (4) auf Basis der Auswertung (304); **dadurch gekennzeichnet, dass**

die Auswertung auf Basis eines Vergleichs des Sternpunktpotentials mit einem Referenzpotential erfolgt;

wobei eine auswertbare Fehlerspannung zwischen Stempunkt- und Referenzpotential durch die Steuereinheit (4) durch das gezielte Einprägen eines Blindstromanteils über die Steuerleitungen (6) in die Statorwicklung des Motors (2) erzeugt wird.

**14.** Verfahren nach Anspruch 13,

wobei die Auswertung des Stempunktpotentials durch einen Vergleich des Stempunktpotentials mit einem Referenzpotential erfolgt;

wobei die Passivierung des Motorfehlers durch Kurzschließen eines Sternpunktsystems erfolgt, in dem ein Motorfehler detektiert wurde.

**Claims**

**1.** A detection and control device (1) for detecting a motor fault of an electric motor (2) with star point topology, the detection and control device (1) comprising:

an evaluation unit (3);

a control unit (4);

a return unit (5);

several control lines (6);

wherein the return unit (5) is designed for returning a star point potential of the electric motor (2) to the evaluation unit (3);

wherein the evaluation unit (3) is designed for evaluating the star point potential;

wherein the control unit (4) is designed for passivating a motor fault on the basis of the evaluation;

**characterized in that**

the evaluation takes place on the basis of a comparison of the star point potential with a reference potential;

wherein a fault voltage between star point potential and reference potential, which fault voltage may be evaluated, is generated by the control unit (4) by directed impression of a reactive current component, via the control lines (6), into the stator windings of the motor (2).

**2.** Detection and control device (1) according to claim 1, wherein the evaluation takes place on the basis of a comparison of the star point potential with a reference potential, wherein the reference potential is calculated.

**3.** Detection and control device (1) according to claim 1, wherein the evaluation takes place on the basis of a comparison of the star point potential with a reference potential, wherein the reference potential is generated in an analogue manner.

**4.** Detection and control device (1) according to one of the previous claims, wherein the passivation takes place by short-circuiting a star point system in which a motor fault has been detected.

**5.** Detection and control device (1) according to one of the previous claims, wherein the passivation enables to limit a short-circuit current and a resulting disturbance torque at an electric motor (2).

**6.** Detection and control device (1) according to one of the previous claims, wherein the return unit (5) is designed as a connecting line between a star point of the electric motor (2) and the evaluation unit (3).

7. Detection and control device (1) according to one of the claims 1 to 5, wherein returning the star point potential of the electric motor (2) to the control unit (4) takes place via the control lines (6) such that the control lines (6) also assume the function of the return unit (5), and the control unit (4) also assumes the function of the evaluation unit (3).

8. Detection and control device (1) according to one of the previous claims, wherein the evaluation unit (3) and the control unit (4) are designed to be integrated with each other.

9. An electric motor with a detection and control device (1) according to one of the claims 1 to 8.

10. An aircraft (201) with a detection and control device (1) according to one of the claims 1 to 8.

11. A landing flap drive system (202) with a detection and control device (1) according to one of the claims 1 to 8.

12. Use of a detection and control device (1) according to one of the claims 1 to 8 in an aircraft (201).

13. A method for detecting a motor fault of an electric motor (2) with star point topology, the method comprising the steps of:

   providing an evaluation unit (3), a control unit (4), a return unit (5) and several control lines (6, 301);
   returning a star point potential of the electric motor (2) by the return unit (5) to the evaluation unit (3, 302);
   evaluating the star point potential by the evaluation unit (3, 303);
   passivating the motor fault by the control unit (4) on the basis of the evaluation (304);
   **characterized in that**
   the evaluation of the star point potential takes place by a comparison of the star point potential with a reference potential;
   wherein a fault voltage between star point potential and reference potential, which fault voltage may be evaluated, is generated by the control unit (4) by directed impression of a reactive current component, via the control lines (6) into the stator windings of the motor (2).

14. Method according to claim 13,
   wherein evaluating the star point potential takes place by a comparison of the star point potential with a reference potential;
   wherein passivating the motor fault takes place by short-circuiting a star point system, in which a motor fault has been detected.

**Revendications**

1. Dispositif de détection et de commande (1) conçu pour détecter une panne moteur d'un moteur électrique (2) présentant une topologie de points neutres, le dispositif de détection et de commande (1) présentant :

   - une unité d'évaluation (3) ;
   - une unité de commande (4) ;
   - une unité de rétroaction (5) ;
   - plusieurs lignes de commande (6) ;

   l'unité de rétroaction (5) étant conçue pour retourner un potentiel de point neutre du moteur électrique (2) à l'unité d'évaluation (3) ;
   l'unité d'évaluation (3) étant conçue pour évaluer le potentiel de point neutre ;
   l'unité de commande (4) étant conçue pour passiver une panne moteur sur la base de l'évaluation ; **caractérisé par le fait que**
   l'évaluation s'effectue sur la base d'une comparaison du potentiel de point neutre avec un potentiel de référence ;
   une tension de défaut pouvant être évaluée entre le potentiel de point neutre et le potentiel de référence étant générée par l'unité de commande (4) en introduisant de manière ciblée une partie de courant réactif via les lignes de commande (6) dans l'enroulement de stator du moteur (2).

2. Dispositif de détection et de commande (1) selon la revendication 1, l'évaluation s'effectuant sur la base d'une comparaison du potentiel de point neutre avec un potentiel de référence, le potentiel de référence étant calculé.

**3.** Dispositif de détection et de commande (1) selon la revendication 1, l'évaluation s'effectuant sur la base d'une comparaison du potentiel de point neutre avec un potentiel de référence, le potentiel de référence étant calculé de manière analogue.

**4.** Dispositif de détection et de commande (1) selon l'une des revendications précédentes, la passivation s'effectuant par court-circuitage d'un système de point neutre dans lequel une panne moteur a été détectée.

**5.** Dispositif de détection et de commande (1) selon l'une des revendications précédentes, la passivation permettant la limitation d'un courant de court-circuit et d'un couple perturbateur en résultant dans un moteur électrique (2).

**6.** Dispositif de détection et de commande (1) selon l'une des revendications précédentes, l'unité de rétroaction (5) étant conçue comme une ligne de liaison entre un point neutre du moteur électrique (2) et l'unité d'évaluation (3).

**7.** Dispositif de détection et de commande (1) selon l'une des revendications 1 à 5, la rétroaction du potentiel de point neutre du moteur électrique (2) à l'unité de commande (4) s'effectuant via les lignes de commande (6), de sorte que les lignes de commande (6) prennent la fonction de l'unité de rétroaction (5) et l'unité de commande (4) prend la fonction de l'unité d'évaluation (3).

**8.** Dispositif de détection et de commande (1) selon l'une des revendications précédentes, l'unité d'évaluation (3) et l'unité de commande (4) étant conçues intégrées l'une à l'autre.

**9.** Moteur électrique (2) avec un dispositif de détection et de commande (1) selon l'une des revendications 1 à 8.

**10.** Aéronef (201) avec un dispositif de détection et de commande (1) selon l'une des revendications 1 à 8.

**11.** Système d'entraînement de volet d'atterrissage (202) avec un dispositif de détection et de commande (1) selon l'une des revendications 1 à 8.

**12.** Utilisation d'un dispositif de détection et de commande (1) selon l'une des revendications 1 à 8 dans un aéronef (201).

**13.** Procédé de détection d'une panne moteur d'un moteur électrique (2) présentant une topologie de points neutres, le procédé présentant les étapes de :

- mise à disposition d'une unité d'évaluation (3), d'une unité de commande (4), d'une unité de rétroaction (5) et de plusieurs lignes de commande (6, 301) ;
- rétroaction d'un potentiel de point neutre du moteur électrique (2) par l'intermédiaire de l'unité de rétroaction (5) à l'unité d'évaluation (3, 302) ;
- évaluation du potentiel de point neutre par l'unité d'évaluation (3, 303) ;
- passivation de la panne moteur par l'unité de commande (4) sur la base de l'évaluation (304) ;

**caractérisé par le fait que**
l'évaluation s'effectue sur la base d'une comparaison du potentiel de point neutre avec un potentiel de référence ;
une tension de défaut pouvant être évaluée entre le potentiel de point neutre et le potentiel de référence étant générée par l'unité de commande (4) en introduisant de manière ciblée une partie de courant réactif via les lignes de commande (6) dans l'enroulement de stator du moteur (2).

**14.** Procédé selon la revendication 13,
l'évaluation du potentiel de point neutre s'effectuant par une comparaison du potentiel de point neutre avec un potentiel de référence ;
la passivation de la panne moteur s'effectuant par court-circuitage d'un système de point neutre dans lequel une panne moteur a été détectée.

Fig. 1

Fig. 2

EP 2 377 239 B1

Fig. 3

EP 2 377 239 B1

400

401

402

404

403

# Fig. 4

500

$i_1$

501

507

$N_1, L_1, R_1$

502

~ 503

$e_1$

504

$N_2, L_2, R_2$

505

$i_2$

~ 506

$u_1$

$e_2$

$u_2$

507

# Fig. 5

**Fig. 6**

**Fig. 7**

EP 2 377 239 B1

Fig. 8

Fig. 9

EP 2 377 239 B1

1600
1601
1604
$i_1$
$L_{1S} = L\ (1-k)$
1602
1601
1603
$M = L^* k$
$u_1$
1604
1601

## Fig. 10

1700
1701
1705
$i_1$
$L_{1S} = L\ (1-k)$
$L'_{2S} = L\ (1-k)$
$i'_2$
1702
1703
$M = L^* k$
1704
$u_1$
1705
1701

## Fig. 11

Fig. 12

Fig. 13

Fig. 14

Fig. 15

Fig. 16

Fig. 17

Fig. 18

EP 2 377 239 B1

Fig. 19

Fig. 20

Fig. 21

Fig. 22

EP 2 377 239 B1

Fig. 23

Fig. 24

Fig. 25

Fig. 26

Fig. 27

15/20

Fig. 28

Fig. 29

Fig. 30

Fig. 31

EP 2 377 239 B1

Fig. 32

Fig. 33

Fig. 34

Fig. 35

Fig. 36

Fig. 37

Fig. 38